# EUROPEAN PATENT SPECIFICATION

(11) **EP 1 585 797 B1**
(45) Date of publication and mention of the grant of the patent: **27.08.2008**
(21) Application number: 03789550.5
(22) Date of filing: 19.12.2003
(51) Int. Cl.: C09K 11/06, H05B 33/14, H01L 51/50

(54) **ELECTROLUMINESCENT MATERIALS AND DEVICES**
ELEKTROLUMINESZENTE MATERIALIEN UND VORRICHTUNGEN
MATERIAUX ET DISPOSITIFS ELECTROLUMINESCENTS

(30) Priority: 24.12.2002 GB 0230072
(43) Date of publication of application: 19.10.2005
(73) Proprietor: OLED-T LIMITED, 8 Kinetic Crescent Innova Park Enfield EN3 7XH (GB)
(72) Inventor: KATHIRGAMANATHAN, Poopathy, North Harrow HA2 7NN (GB); PRICE, Richard, London N8 0JB (GB); GANESHAMURUGAN, Subramaniam, London N15 4BB (GB); PARAMASWARA, Gnanamoly, London N208EB (GB); KUMARAVERL, Muttulingham, Middlesex UB6 7AH (GB); PARTHEEPAN, Arumugam, Mitcham, Surrey CR4 1AG (GB); SELVARANJAN, Selvadurai, Surrey SM3 8ET (GB); ANTIPAN-LARA, Juan, London N16 7SB (GB); SURENDRAKUMAR, Sivagnanasundram, Middelesex HA8 6DL (GB)
(74) Representative: Lucas, Brian Ronald
(86) International application number: PCT/GB2003/005573
(87) International publication number: WO 2004/058913

(56) References cited:
- WO-A-99/53724
- DATABASE CA [Online] CHEMICAL ABSTRACTS SERVICE, COLUMBUS, OHIO, US; SUZUKI, MUTSUKO ET AL: "Organic electroluminescent devices" XP002277664 retrieved from STN Database accession no. 134:245058 -& JP 2001 076879 A (MATSUSHITA ELECTRIC INDUSTRIAL CO., LTD., JAPAN) 23 March 2001 (2001-03-23)
- DATABASE CA [Online] CHEMICAL ABSTRACTS SERVICE, COLUMBUS, OHIO, US; KIM, YOUNG KYU ET AL: "Organometallic light-emitting substances, their manufacture, and organic electroluminescent devices using them" XP002277665 retrieved from STN Database accession no. 132:187445 -& JP 2000 053957 A (ADVANCED TECHNICAL RESEARCH INSTITUTE, S. KOREA) 22 February 2000 (2000-02-22)
- DATABASE CA [Online] CHEMICAL ABSTRACTS SERVICE, COLUMBUS, OHIO, US; UEDA, HIDEAKI ET AL: "Organic electroluminescent device" XP002277666 retrieved from STN Database accession no. 132:129805 -& JP 2000 030864 A (MINOLTA CAMERA CO., LTD., JAPAN) 28 January 2000 (2000-01-28)

## Description

### Field of the invention

The present invention relates to an electroluminescent device.

### Background to the invention

Materials that emit light when an electric current is passed through them are well known and used in a wide range of display applications. Liquid crystal devices and devices which are based on inorganic semiconductor systems are widely used; however these suffer from the disadvantages of high energy consumption, high cost of manufacture, low quantum efficiency and the inability to make flat panel displays. Organic polymers have been proposed as useful in electroluminescent devices, but it is not possible to obtain pure colours, they are expensive to make and have a relatively low efficiency. Patent application WO98/58037 describes a range of lanthanide complexes which can be used in electroluminescent devices which have improved properties and give better results. Patent Applications PCT/GB98/01773, PCT/G899/03619, PCT/GB99/04030, PCT/GB99/04024, PCT/GB99/04028, PCT/GB00/00268 describe electroluminescent complexes, structures and devices using rare earth chelates. Another compound which has been proposed as an electroluminescent material for use in electroluminescent device is aluminium quinolate.

US Patent 3,995,299 (Partridge) discloses an electroluminescent device comprising in sequence, an anode, an organic hole injecting and transporting zone, a luminescent zone, an electron transporting zone and a cathode. The luminescent zone can be an organic polymer such as a polyvinyl carbazole doped with a fluorescent dye such as a perylene, an acridine, etc. US Patent 4769292 (Kodak) discloses an electroluminescent device comprising in sequence, an anode, an organic hole injecting and transporting zone, a luminescent zone, and a cathode. The EL device is characterized in that the luminescent zone is formed by a thin film of less than 1 µm in thickness comprised of an organic host material and a fluorescent material capable of emitting light. The luminescent zone exemplified in the specification contains aluminium quinolate, and other metal quinolates with a valence of 1 to 3 are also referred to and claimed.

WO 99/53724 discloses means for tuning the emission spectrum of OLEDs while retaining high luminescence efficiency. The e mission spectrum of a polar luminescent molecule was disclosed as being wavelength shifted by as much as 70 nm when doped into a conductive host in a vacuum-deposited OLED. The effect was attributed to changes in the average dipole moment of the host thin film that were induced by the addition of highly polar dopant molecules, this phenomenon being referred to as a "solid state solvation effect" in analogy to similar effects previously identified in solution chemistry. In a first series of experiments red, orange and yellow OLEDs were demonstrated which had an emissive layer comprising Alq₃ (dipole moment 5.5 D) doped with a laser dye known as DCM2 (ground state dipole moment 11.3D). 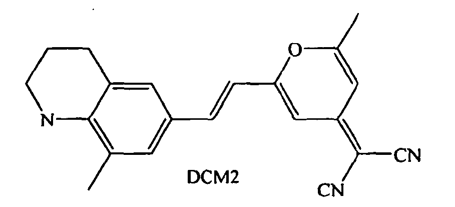 The broad emission spectrum of the OLEDs yielded a saturated colour that was dependent on the concentration of the DCM2 in the Alq₃, the electroluminescence peak shifting from 605 nm for less highly doped DCM2 in Alq₃ to 685 nm for more highly doped Alq₃. The reported energy shift was attributed to self-polarization of the Alq₃ due to dipole-dipole interactions. A second series of experiments involved Alq₃ together with a dye dopant and a polarization dopant having a high dipole moment for shifting the emission spectrum of the dye by changing the polarity of the medium. The effect of polar molecule doping was said to be enhanced if the matrix were nonpolar and for that purpose it was suggested that *inter alia* there should be used as host zirconium quinolate (Zrq₄) which has zero dipole moment. However, making and testing an OLED using zirconium quinolate as host was not reported. A third group of experiments reported the doping of DCM2 into N,N'-diphenyl-N,N'-bis(3-methylphenyl)-1,1'-biphenyl-4,4'-diamine (TPD), a mixture of TPD and AlQ₃ or 4,4'-bis[N-(1-naphthyl)-N-phenylamino]-biphenyl (α-NPD).

### Summary of the invention

It has now been found that replacement of aluminium quinolate by zirconium or hafnium quinolate as host material in the electroluminescent layer of an OLED results in a marked increase in efficiency and improved luminance, lower current density with no reduction or with an improvement in other properties and improved emitted colour compared with aluminium quinolate.

The present invention relates to the use in an electroluminescent device comprising (i) a first electrode, (ii) a layer of electroluminescent composition which comprises a metal quinolate doped with 10⁻³-10 mole% of a fluorescent dopant and (iii) a second electrode of zirconium or hafnium quinolate as said metal quinolate to give improved luminance efficiency measurable as cd A⁻¹, luminance measurable as cd m⁻² at 20 mA cm⁻² and reduced turn-on voltage compared with aluminium quinolate.

### Description of preferred features

### Electroluminescent layer

As discussed in US 4769292, the presence of the fluoresecent material permits a choice from among a wide latitude of wavelengths of light emission.

By blending with the zirconium quinolate a minor amount of a fluorescent material capable of emitting light in response to hole-electron recombination, the hue of the light emitted from the luminescent zone can be modified. In theory, if an organo metallic complex and a fluorescent material could be found for blending which have exactly the same affinity for hole-electron recombination, each material should emit light upon injection of holes and electrons in the luminescent zone. The perceived hue of light emission would be the visual integration of both emissions.

Since imposing such a balance of the zirconium quinolate and fluorescent materials is highly limiting, it is preferred to choose the fluorescent material so that it provides the favoured sites for light emission. When only a small proportion of fluorescent material providing favoured sites for light emission is present, peak intensity wavelength emissions typical of the zirconium quinolate can be entirely eliminated in favour of a new peak intensity wavelength emission attributable to the fluorescent material. While the minimum proportion of fluorescent material sufficient to achieve this effect varies by the specific choice of organo metallic complex and fluorescent materials, in no instance is it necessary to employ more than about 10 mole percent fluorescent material, based on moles of zirconium quinolate and seldom is it necessary to employ more than 1 mole percent of the fluorescent material. On the other hand, for any organo metallic complex capable of emitting light in the absence of fluorescent material, limiting the fluorescent material present to extremely small amounts, typically less than about 10⁻³ mole percent, based on organo metallic complex, can result in retaining emission at wavelengths characteristic of the organo metallic complex. Thus, by choosing the proportion of a fluorescent material capable of providing favoured sites for light emission, either a full or partial shifting of emission wavelengths can be realized. This allows the spectral emissions of the EL devices of this invention to be selected and balanced to suit the application to be served.

Choosing fluorescent materials capable of providing favoured sites for light emission, necessarily involves relating the properties of the fluorescent material to those of the zirconium quinolate. The zirconium quinolate can be viewed as a collector for injected holes and electrons with the fluorescent material providing the molecular sites for light emission. One important relationship for choosing a fluorescent material capable of modifying the hue of light emission when present in a organo metallic complex is a comparison of the reduction potentials of the two materials. The fluorescent materials demonstrated to shift the wavelength of light emission have exhibited a less negative reduction potential than that of zirconium quinolate. Reduction potentials, measured in electron volts, have been widely reported in the literature along with varied techniques for their measurement. Since it is a comparison of reduction potentials rather than their absolute values which is desired, it is apparent that any accepted technique for reduction potential measurement can be employed, provided both the fluorescent and organo metallic complex reduction potentials are similarly measured. A preferred oxidation and reduction potential measurement techniques is reported by R. J. Cox, Photographic Sensitivity, Academic Press, 1973, Chapter 15.

A second important relationship for choosing a fluorescent material capable of modifying the hue of light emission when present in a organo metallic complex is a comparison of the bandgap potentials of the two materials. The fluorescent materials demonstrated to shift the wavelength of light emission have exhibited a lower bandgap potential than that of the organo metallic complex. The bandgap potential of a molecule is taken as the potential difference in electron volts (eV) separating its ground state and first singlet state. Bandgap potentials and techniques for their measurement have been widely reported in the literature. The bandgap potentials herein reported are those measured in electron volts (eV) at an absorption wavelength which is bathochromic to the absorption peak and of a magnitude one tenth that of the magnitude of the absorption peak. Since it is a comparison of bandgap potentials rather than their absolute values which is desired, it is apparent that any accepted technique for bandgap measurement can be employed, provided both the fluorescent and organo metallic complex band gaps are similarly measured. One illustrative measurement technique is disclosed by F. Gutman and L. E. Lyons, Organic Semiconductors, Wiley, 1967, Chapter 5.

Where a metal complex or organometallic complex is chosen, which is itself capable of emitting light in the absence of the fluorescent material, it has been observed that suppression of light emission at the wavelengths of emission characteristics of the organo metallic complex alone and enhancement of emission at wavelengths characteristic of the fluorescent material occurs when spectral coupling of the organo metallic complex and fluorescent material is achieved. By spectral coupling it is meant that an overlap exists between the wavelengths of emission characteristic of the organo metallic complex alone and the wavelengths of light absorption of the fluorescent material in the absence of the organo metallic complex. Optimal spectral coupling occurs when the wavelength of emission of the organometallic complex alone is ±25nm the maximum absorption of the fluorescent material alone. In practice advantageous spectral coupling can occur with peak emission and absorption wavelengths differing by up to 100 nm or more, depending on the width of the peaks and their hypsochromic and bathochromic slopes. Where less than optimum spectral coupling between the organo metallic complex and fluorescent materials is contemplated, a bathochromic as compared to a hypsochromic displacement of the fluorescent material produces more efficient results.

Although the foregoing discussion has been undertaken by reference to organo metallic complexes which are known to themselves emit light in response to hole and electron injection, in fact light emission by the organo metallic complex itself can entirely cease where light emission by the fluorescent material is favoured by any one or combination of the various relationships noted above. It is appreciated that shifting the role of light emission to the fluorescent material allows a still broader range of choices of organo metallic complexes. For example, one fundamental requirement of a material chosen to emit light is that it must exhibit a low extinction coefficient for light of the wavelength it emits to avoid internal absorption.

### Fluorescent materials

Useful fluorescent materials are those capable of being blended with the metal quinolate e.g. zirconium quinolate and fabricated into thin films satisfying the thickness ranges described above forming the luminescent zones of the EL devices of this invention. While crystalline organo metallic complexes do not lend themselves to thin film formation, the limited amounts of fluorescent materials present in the zirconium quinolate permit the use of fluorescent materials which are alone incapable of thin film formation. Preferred fluorescent materials are those which form a common phase with the zirconium quinolate. Fluorescent dyes constitute a preferred class of fluorescent materials, since dyes lend themselves to molecular level distribution in the organo metallic complex. Although any convenient technique for dispersing the fluorescent dyes in the organo metallic complexes can be undertaken, preferred fluorescent dyes are those which can be vacuum vapour deposited along with the zirconium quinolate. Assuming other criteria, noted above, are satisfied, fluorescent laser dyes are recognized to be particularly useful fluorescent materials for use in the organic EL devices of this invention. Dopants which can be used include diphenylacridone, coumarins, perylene and their derivatives.

Useful fluorescent dopants are disclosed in US 4769292.

The preferred dopants are coumarins such as those of formula 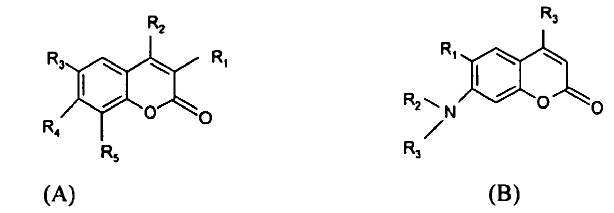 where R₁ is chosen from the group consisting of hydrogen, carboxy, alkanoyl, alkoxycarbonyl, cyano, aryl, and a heterocylic aromatic group, R₂ is chosen from the group consisting of hydrogen, alkyl, haloalkyl, carboxy, alkanoyl, and alkoxycarbonyl, R₃ is chosen from the group consisting of hydrogen and alkyl, R₄ is an amino group, and R₅ is hydrogen, or R₁ or R₂ together form a fused carbocyclic ring, and/or the amino group forming R⁴ completes with at least one of R⁴ and R⁶ a fused ring.

The alkyl moieties in each instance contain from 1 to 5 carbon atoms, preferably 1 to 3 carbon atoms. The aryl moieties are preferably phenyl groups. The fused carbocyclic rings are preferably five, six or seven membered rings. The heterocyclic aromatic groups contain 5 or 6 membered heterocyclic rings containing carbon atoms and one or two heteroatoms chosen from the group consisting of oxygen, sulfur, and nitrogen. The amino group can be a primary, secondary, or tertiary amino group. When the amino nitrogen completes a fused ring with an adjacent substituent, the ring is preferably a five or six membered ring. For example, R⁴ can take the form of a pyran ring when the nitrogen atom forms a single ring with one adjacent substituent (R³ or R⁵) or a julolidine ring (including the fused benzo ring of the coumarin) when the nitrogen atom forms rings with both adjacent substituents R₃ and R₅.

The following are illustrative fluorescent coumarin dyes known to be useful as laser dyes:
FD-1 7-Diethylamino-4-methylcoumarin,
FD-2 4,6-Dimethyl-7-ethylaminocoumarin,
FD-3 4-Methylumbelliferone,
FD-4 3-(2'-Benzothiazolyl)-7-diethylaminocoumarin,
FD-5 3-(2'-Benzimidazolyl)-7-N,N-diethylaminocoumarin,
FD-6 7-Amino-3-phenylcoumarin,
FD-7 3-(2'-N-Methylbenzimidazolyl)-7-N,Ndiethylaminocoumarin,
FD-8 7-Diethylamino-4-trifluoromethylcoumarin,
FD-9 2,3,5,6-1H,4H-Tetrahydro-8-methylquinolazino[9,9a,1-gh]coumarin,
FD-10 Cyclopenta[c]julolindino[9,10-3]-11H-pyran-11-one,
FD-11 7-Amino-4-methylcoumarin,
FD-12 7-Dimethylaminocyclopenta[c]coumarin,
FD-13 7-Amino-4-trifluoromethylcoumarin,
FD-14 7-Dimethylamino-4-trifluoromethylcoumarin,
FD-15 1,2,4,5,3H,6H,10H-Tetrahydro-8-trifluoromethyl[1]benzopyrano [9,9a,1-gh]quinolizin-10-one,
FD-16 4-Methyl-7-(sulfomethylamino)coumarin sodium salt,
FD-17 7-Ethylamino-6-methyl-4-trifluoromethylcoumarin,
FD-18 7-Dimethylamino-4-methylcoumarin,
FD-19 1,2,4,5,3H,6H,10H-Tetrahydro-carbeihoxy[1]benzopyrano[9,9a,1-gh]quinolizino-10-one,
FD-20 9-Acetyl-1,2,4,5,3H,6H,10H-tetrahydro[1]benzopyrano[9,9a,1-gh]quinolizino-10-one,
FD-21 9-Cyano-1,2,4,5,3H,6H,10H-tetrahydro[1]benzopyrano[9,9a,1-gh]quinolizino-10-one,
FD22 9-(t-Butoxycarbonyl)-1,2,4,5,3H,6H,10H-tetrahyro[1]benzopyrano [9,9a,1-gh]quinolizino-10-one,
FD-23 4-Methylpiperidino[3,2-g]coumarin,
FD-24 4-Trifluoromethylpiperidino[3,2-g]coumarin,
FD-25 9-Carboxy-1,2,4,5,3H,6H,10H-tetrahydro[1]benzopyrano[9,9a1-gh]quinolizino-10-one,
FD-26 N-Ethyl-4-trifluoromethylpiperidino[3,2-g].

Other examples of coumarins are given below.

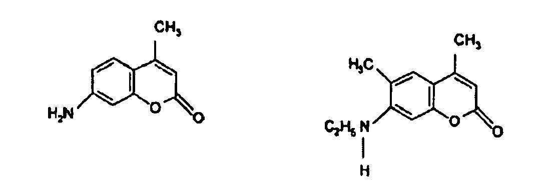

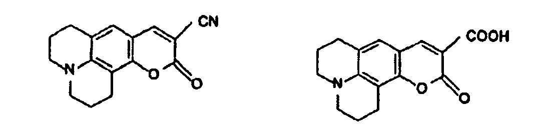

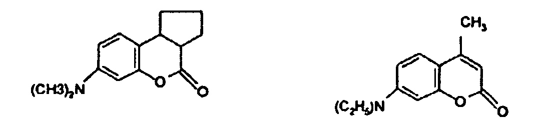

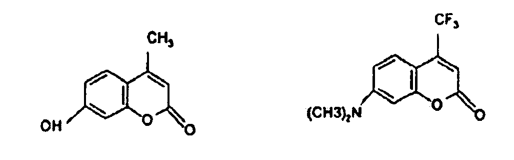

Other dopants include salts of bis benzene sulphonic acid such as 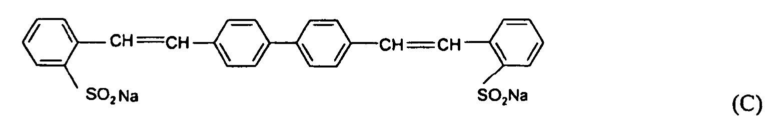 and perylene and perylene derivatives and dopants of the formulae below: 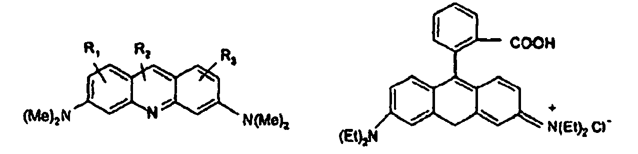 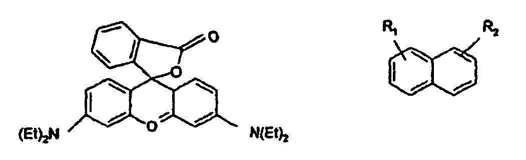 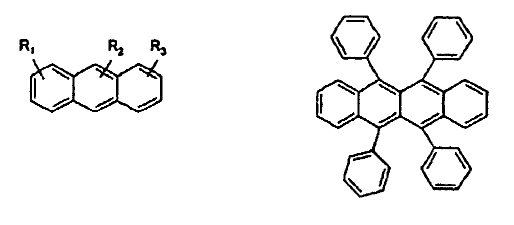 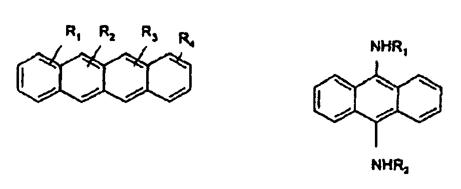 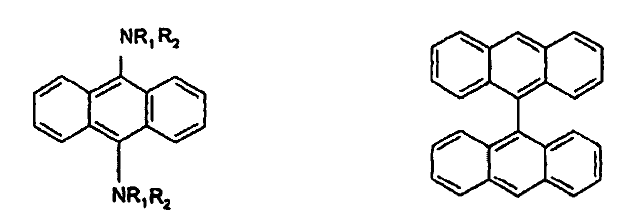 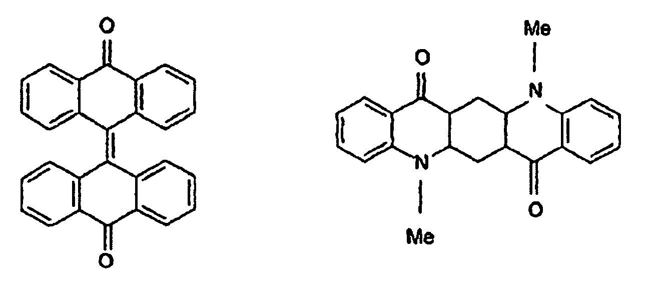 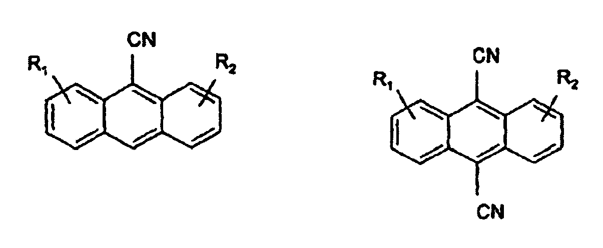 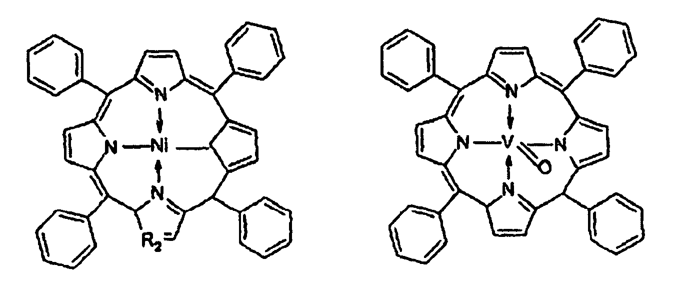 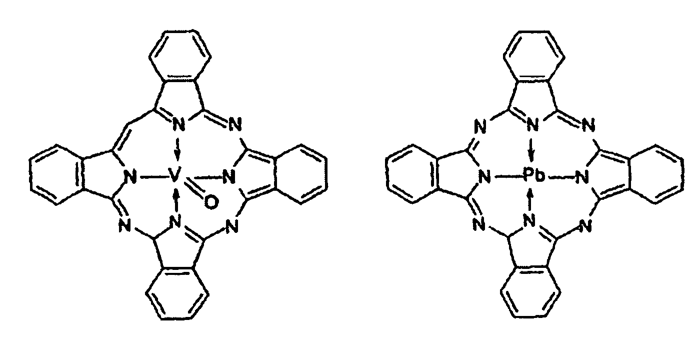 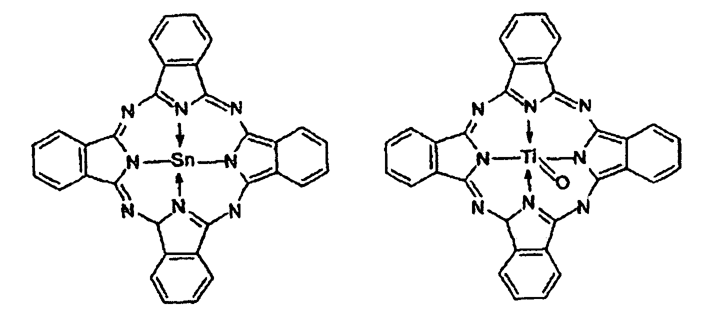 where R₁, R₂, R₃ and R₄ are R, R₁, R₂, R₃ and R₄ can be the same or different and are selected from hydrogen, hydrocarbyl groups, substituted and unsubstituted aromatic, heterocyclic and polycyclic ring structures, fluorocarbons such as trifluoryl methyl groups, halogens such as fluorine or thiophenyl groups; R, R₁, R₂, R₃ and R₄ can also form substituted and unsubstituted fused aromatic, heterocyclic and polycyclic ring structures and can be copolymerisable with a monomer e.g. styrene. R, R_{1,} R_{2,} R₃ and R₄ can also be unsaturated alkylene groups such as vinyl groups or groups

-C-CH₂=CH₂- R

where R is as above.

Other dopants are dyes such as the fluorescent 4-dicyanomethylene-4H-pyrans and 4-dicyanomethylene-4H-thiopyrans, e.g. the fluorescent dicyanomethylenepyran and thiopyran dyes. Useful fluorescent dyes can also be selected from among known polymethine dyes, which include the cyanines, merocyanines, complex cyanines and merocyanines (i.e. tri-, tetra- and poly-nuclear cyanines and merocyanines), oxonols, hemioxonols, styryls, merostyryls, and streptocyanines. The cyanine dyes include, joined by a methine linkage, two basic heterocyclic nuclei, such as azolium or azinium nuclei, for example, those derived from pyridinium, quinolinium, isoquinolinium, oxazolium, thiazolium, selenazolium, indazolium, pyrazolium, pyrrolium, indolium, 3H-indolium, imidazolium, oxadiazolium, thiadioxazolium, benzoxazolium, benzothiazolium, benzoselenazolium, benzotellurazolium, benzimidazolium, 3H- or 1H-benzoindolium, naphthoxazolium, naphthothiazolium, naphthoselenazolium, naphthotellurazolium, carbazolium, pyrrolopyridinium, phenanthrothiazolium, and acenaphthothiazolium quaternary salts. Other useful classes of fluorescent dyes are 4-oxo-4H-benz-[d,e]anthracenes and pyrylium, thiapyrylium, selenapyrylium, and telluropyrylium dyes.

### Synthesis of quinolates

Metal quinolates can be synthesised by the reaction of a metal compound such as a salt, ethoxide or alkyl 8-hydroxyquinoline in accordance with well known methods. For electroluminescent materials the reaction preferably takes place in a nitrile solvent such as acetonitrile, phenyl nitrile, tolyl nitrile, etc.

### Device structure

The invention provides an electroluminescent device which comprises (i) a first electrode, (ii) a layer of a electroluminescent compound as described above and (iii) a second electrode.

The first electrode can function as the anode and the second electrode can function as the cathode and preferably there is a layer of a hole transporting material between the anode and the layer of the electroluminescent compound.

The first electrode is preferably a transparent substrate such as a conductive glass or plastic material which acts as the anode; preferred substrates are conductive glasses such as indium tin oxide coated glass, but any glass which is conductive or has a conductive layer such as a metal or conductive polymer can be used. Conductive polymers and conductive polymer coated glass or plastics materials can also be used as the substrate.

The cathode is preferably a low work function metal, e.g. aluminium, calcium, lithium, silver/magnesium alloys, rare earth metal alloys etc; aluminium is a preferred metal. A metal fluoride such as an alkali metal, rare earth metal or their alloys can be used as the second electrode, for example by having a metal fluoride layer formed on a metal.

### Hole transport materials

The hole transport material can be any of the hole transport materials used in electroluminescent devices.

The structural formulae of suitable hole transporting materials are shown below: 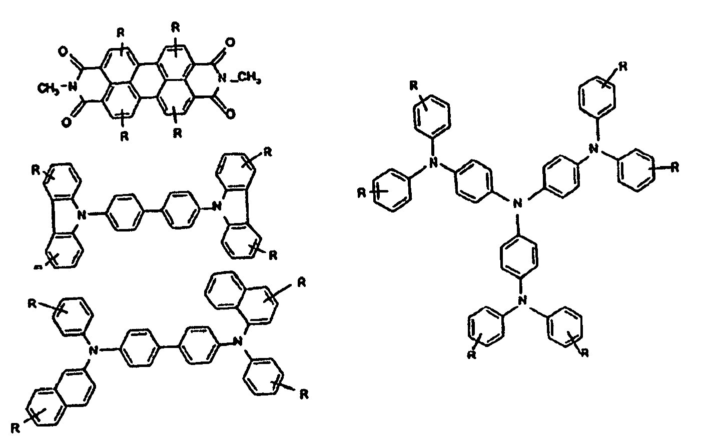 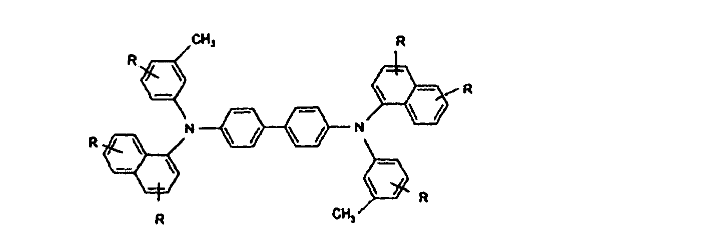 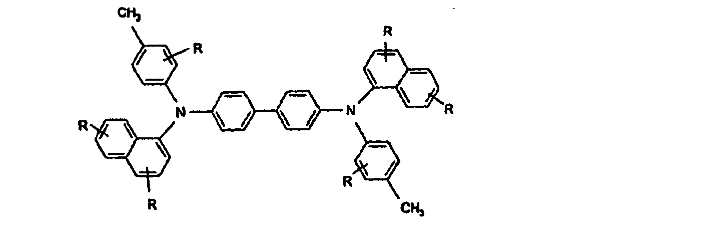 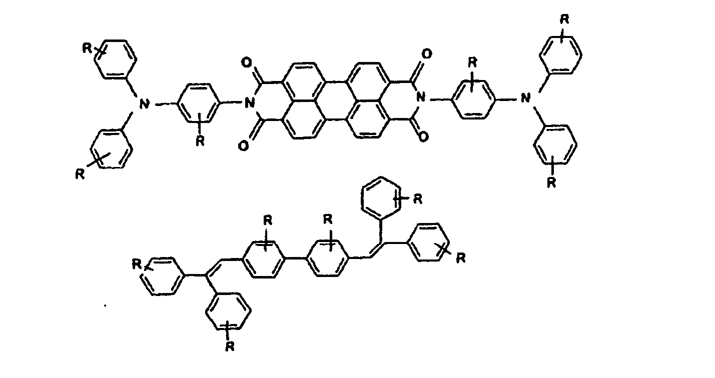 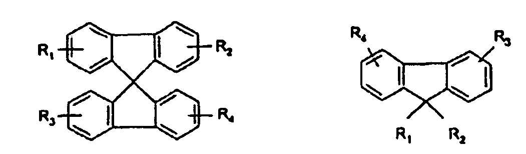 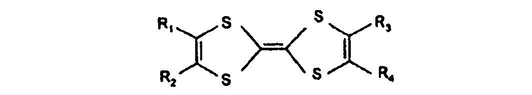 or

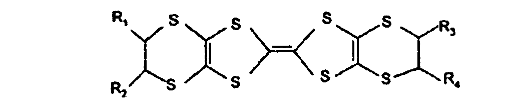

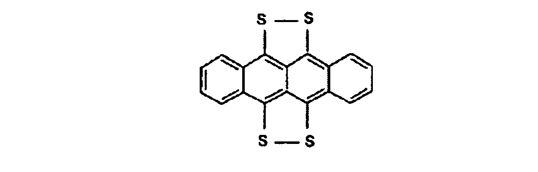

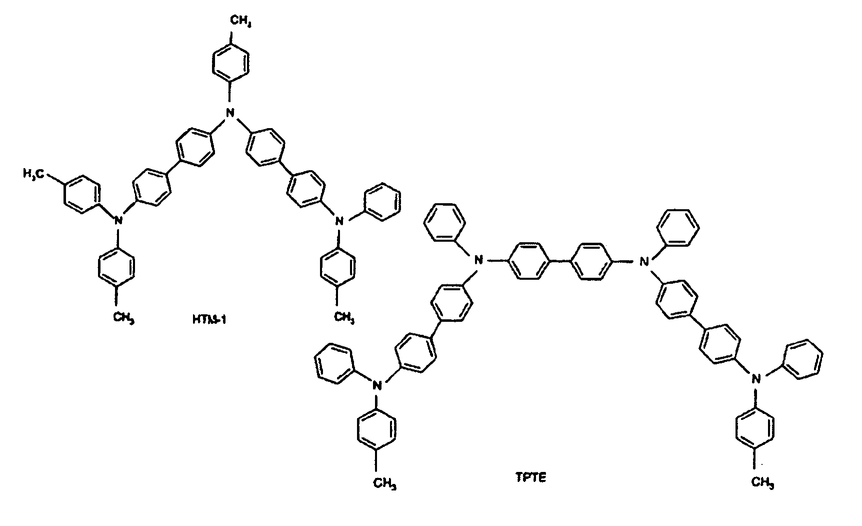

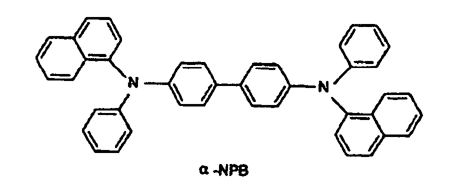

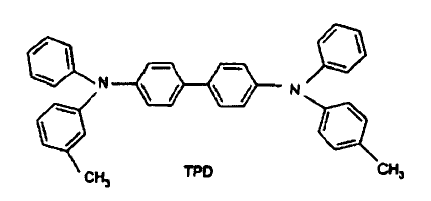

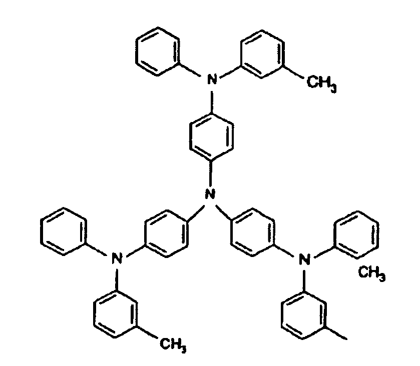

In the above formulae, R₁, R₂ and R₃ can be the same or different and are selected from hydrogen, and substituted and unsubstituted hydrocarbyl groups such as substituted and unsubstituted aliphatic groups, substituted and unsubstituted aromatic, heterocyclic and polycyclic ring structures, fluorocarbons such as trifluoryl methyl groups, halogens such as fluorine or thiophenyl groups; R₁, R₂ and R₃ can also form substituted and unsubstituted fused aromatic, heterocyclic and polycyclic ring structures and can be copolymerisable with a monomer, e.g. styrene. X is Se, S or O, Y can be hydrogen, substituted or unsubstituted hydrocarbyl groups, such as substituted and unsubstituted aromatic, heterocyclic and polycyclic ring structures, fluorine, fluorocarbons such as trifluoryl methyl groups, halogens such as fluorine or thiophenyl groups or nitrile.

Examples of R₁ and/or R₂ and/or R₃ include aliphatic, aromatic and heterocyclic alkoxy, aryloxy and carboxy groups, substituted and substituted phenyl, fluorophenyl, biphenyl, phenanthrene, anthracene, naphthyl and fluorene groups alkyl groups such as t-butyl, heterocyclic groups such as carbazole.

The hole transporting material can in particular be α-NBP or TPD.

Other hole transporting materials can be amine complexes such as poly (vinylcarbazole), an unsubstituted or substituted polymer of an amino substituted aromatic compound, a polyaniline, substituted polyanilines, polythiophenes, substituted polythiophenes, polysilanes etc. Examples of polyanilines are polymers of 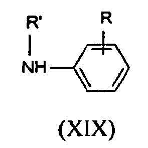 where R is in the ortho - or meta-position and is hydrogen, C1-18 alkyl, C 1-6 alkoxy, amino, chloro, bromo, hydroxy or the group 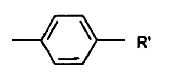 where R is alky or aryl and R' is hydrogen, C1-6 alkyl or aryl with at least one other monomer of formula immediately above. Or the hole transporting material can be a polyaniline; polyanilines which can be used in the present invention have the general formula 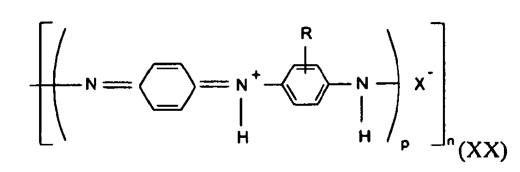 where p is from I to 10 and n is from 1 to 20, R is as defined above and X is an anion, preferably selected from Cl, Br, SO₄, BF₄, PF₆, H₂PO₃, H₂PO₄, arylsulphonate, arenedicarboxylate, polystyrenesulphonate, polyacrylate alkysulphonate, vinylsulphonate, vinylbenzene sulphonate, cellulose sulphonate, camphor sulphonates, cellulose sulphate or a perfluorinated polyanion.

Examples of arylsulphonates are p-toluenesulphonate, benzenesulphonate, 9,10-anthraquinone-sulphonate and anthracenesulphonate; an example of an arenedicarboxylate is phthalate and an example of arenecarboxylate is benzoate.

We have found that protonated polymers of the unsubstituted or substituted polymer of an amino substituted aromatic compound such as a polyaniline are difficult to evaporate or cannot be evaporated. However we have surprisingly found that if the unsubstituted or substituted polymer of an amino substituted aromatic compound is deprotonated, then it can be easily evaporated, i.e. the polymer is evaporable. Preferably evaporable deprotonated polymers of unsubstituted or substituted polymer of an amino substituted aromatic compound are used. The deprotonated unsubstituted or substituted polymer of an amino substituted aromatic compound can be formed by deprotonating the polymer by treatment with an alkali such as ammonium hydroxide or an alkali metal hydroxide such as sodium hydroxide or potassium hydroxide. The degree of protonation can be controlled by forming a protonated polyaniline and de-protonating. Methods of preparing polyanilines are described in an article by A. G. MacDiarmid and A. F. Epstein, Faraday Discussions, Chem Soc.88 P319 1989. The conductivity of the polyaniline is dependant on the degree of protonation with the maximum conductivity being when the degree of protonation is between 40 and 60%, for example, about 50%. Preferably the polymer is substantially fully deprotonated.

A polyaniline can be formed of octamer units. i.e. p is four, e.g. 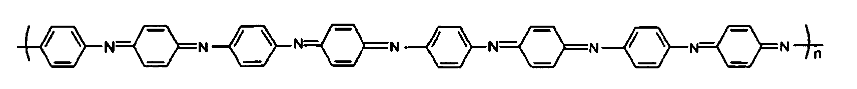 The polyanilines can have conductivities of the order of 1 x 10⁻¹ Siemen cm⁻¹ or higher. The aromatic rings can be unsubstituted or substituted, e.g. by a C1 to 20 alkyl group such as ethyl. The polyaniline can be a copolymer of aniline and preferred copolymers are the copolymers of aniline with o-anisidine, m-sulphanilic acid or o-aminophenol, or o-toluidine with o-aminophenol, o-ethylaniline, o-phenylene diamine or with amino anthracenes.

Other polymers of an amino substituted aromatic compound which can be used include substituted or unsubstituted polyaminonapthalenes, polyaminoanthracenes, polyaminophenanthrenes, etc. and polymers of any other condensed polyaromatic compound. Polyaminoanthracenes and methods of making them are disclosed in US Patent 6,153,726. The aromatic rings can be unsubstituted or substituted, e.g. by a group R as defined above.

Other hole transporting materials are conjugated polymer and the conjugated polymers which can be used can be any of the conjugated polymers disclosed or referred to in US 5807627, PCT/WO90/13148 and PCT/WO92/03490.
The preferred conjugated polymers are poly (p-phenylenevinylene)-PPV and copolymers including PPV. Other preferred polymers are poly(2,5 dialkoxyphenylene vinylene) such as poly (2-methoxy-5-(2-methoxypentyloxy-1,4-phenylene vinylene), poly(2-methoxypentyloxy)-1,4-phenylenevinylene), poly(2-methoxy-5-(2-dodecyloxy-1,4-phenylenevinylene) and other poly(2,5 dialkoxyphenylenevinylenes) with at least one of the alkoxy groups being a long chain solubilising alkoxy group, poly fluorenes and oligofluorenes, polyphenylenes and oligophenylenes, polyanthracenes and oligo anthracenes, polythiophenes and oligothiophenes. In PPV the phenylene ring may optionally carry one or more substituents, e.g. each independently selected from alkyl, preferably methyl, alkoxy, preferably methoxy or ethoxy. Any poly(arylenevinylene) including substituted derivatives thereof can be used and the phenylene ring in poly(p-phenylenevinylene) may be replaced by a fused ring system such as anthracene or naphthlyene ring and the number of vinylene groups in each polyphenylenevinylene moiety can be increased, e.g. up to 7 or higher.

The conjugated polymers can be made by the methods disclosed in US 5807627, PCT/WO90/13148 and PCT/WO92/03490.

The thickness of the hole transporting layer is preferably 20nm to 200nm.

The polymers of an amino substituted aromatic compound such as polyanilines referred to above can also be used as buffer layers with or in conjunction with other hole transporting materials.

### Electron transport material

Optionally there is a layer of an electron transport material between the anode and the electroluminescent material layer. The electron transport material is a material which will transport electrons when an electric current is passed through electron injecting materials include a metal complex such as a metal quinolate, e.g. an aluminium quinolate, lithium quinolate, zirconium quinolate, a cyano anthracene such as 9,10-dicyanoanthracene, cyano-substituted aromatic compounds, tetracyanoquinidodimethane a polystyrene sulphonate or compounds with the structural formulae shown befour in which the phenyl rings can be substituted with substituents R as defined above :

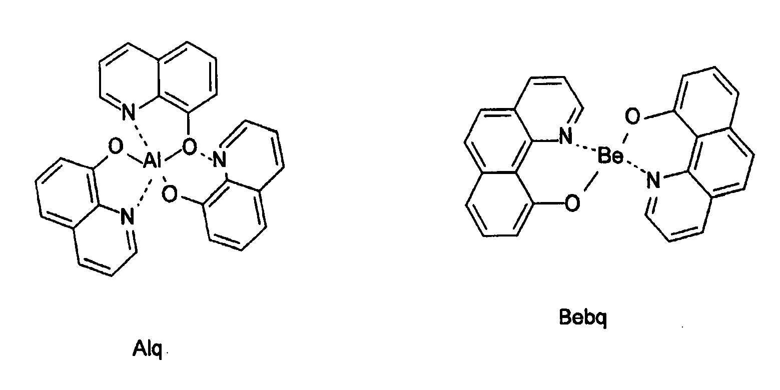

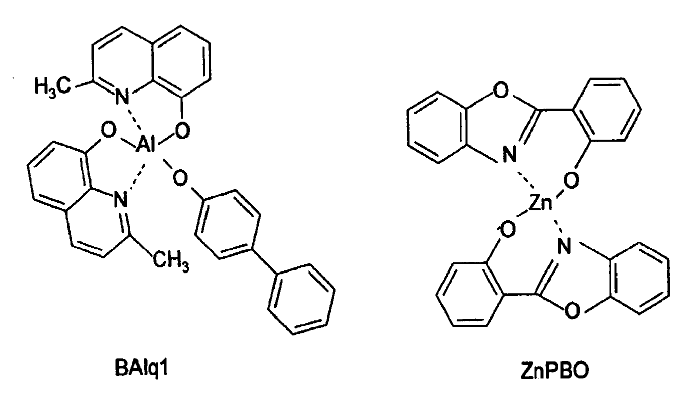

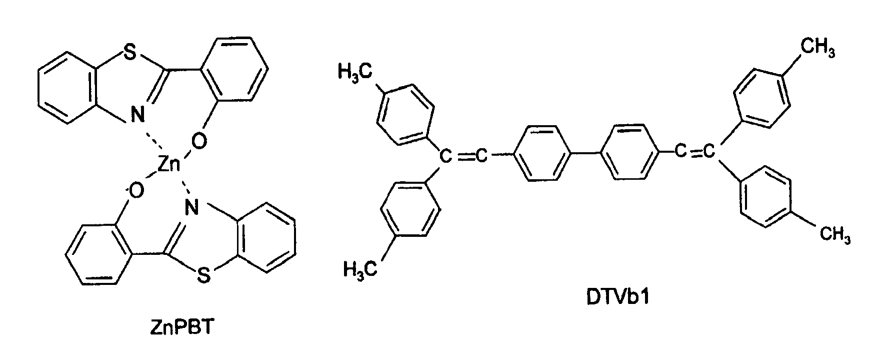

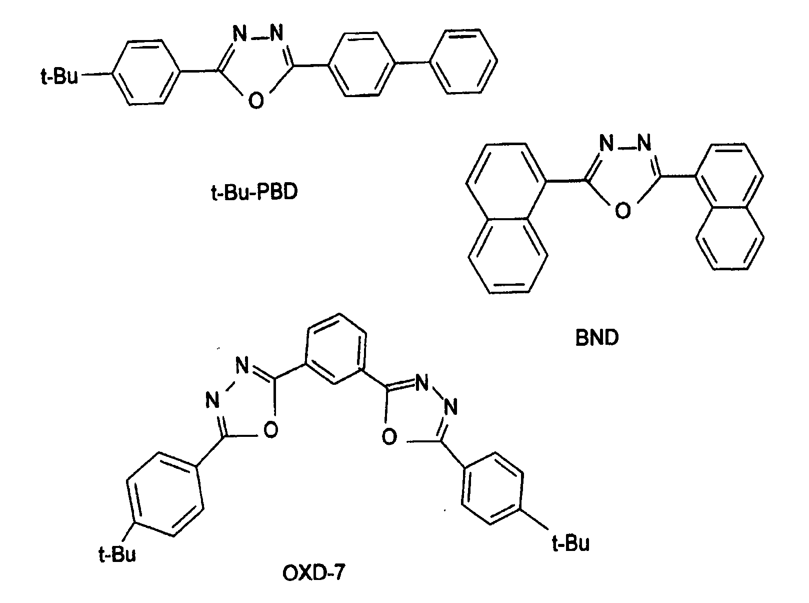

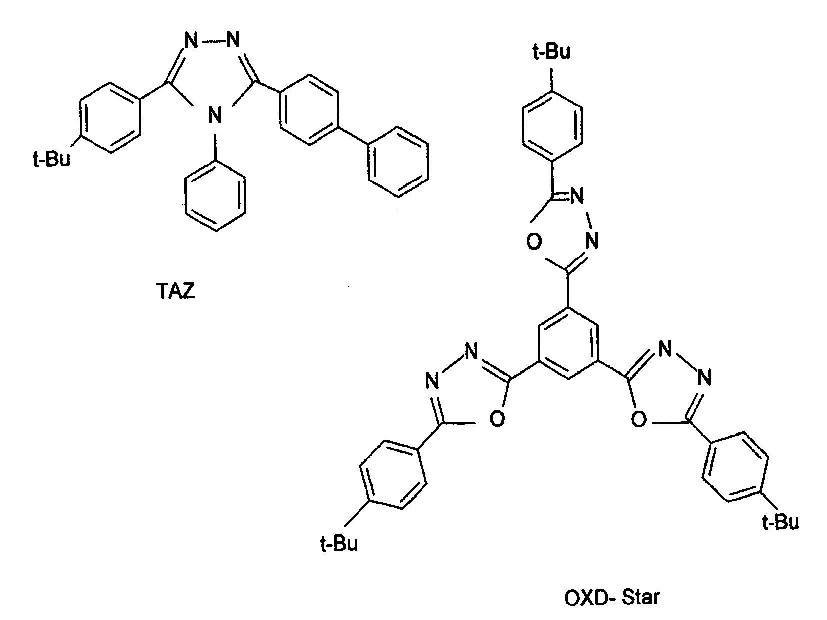

As previously explained, the electroluminescent layer comprises a doped zirconium quinolate, and a preferred electron injecting material is zirconium quinolate.

The improved performance zirconium quinolate compared with the state of the art, aluminium quinolate is particularly shown in the efficiency of the electroluminescent compound although there is an improvement in a range of properties, e.g. lifetime, stability etc.

The invention is further described with reference to the Examples.

### Example 1

A pre-etched ITO coated glass piece (10 x 10cm²) was used. The device was fabricated by sequentially forming on the ITO, by vacuum evaporation using a Solciet Machine, ULVAC Ltd. Chigasaki, Japan the active area of each pixel was 3mm by 3mm, the layers comprised:
ITO(100Ω/ sqr. m ) /CuPc (15nm) / α-NPB (75 nm)/Zrq₄:DPQA (75:0.75nm) /LiF (0.4 nm)/Al.
where ITO is indium tin oxide coated glass, Cu Pc is copper phthalocyanine, α-NPB is as defined in the specification, Zrq₄ is zirconium quinolate and DPQA is diphenylquinacridone.

The Zrq₄ is zirconium quinolate and the Zrq₄:DPQA layer was formed by concurrent vacuum deposition to form a zirconium quinolate layer doped with DPQA. The weight ratio of the Zrq₄ and DPQA is conveniently shown by a relative thickness measurement.

The coated electrodes were stored in a vacuum desiccator over a molecular sieve and phosphorous pentoxide until they were loaded into a vacuum coater (Edwards, 10⁻⁶ torr) and aluminium top contacts made. The devices were then kept in a vacuum desiccator until the electroluminescence studies were performed.

The ITO electrode was always connected to the positive terminal. The current vs. voltage studies were carried out on a computer controlled Keithly 2400 source meter.

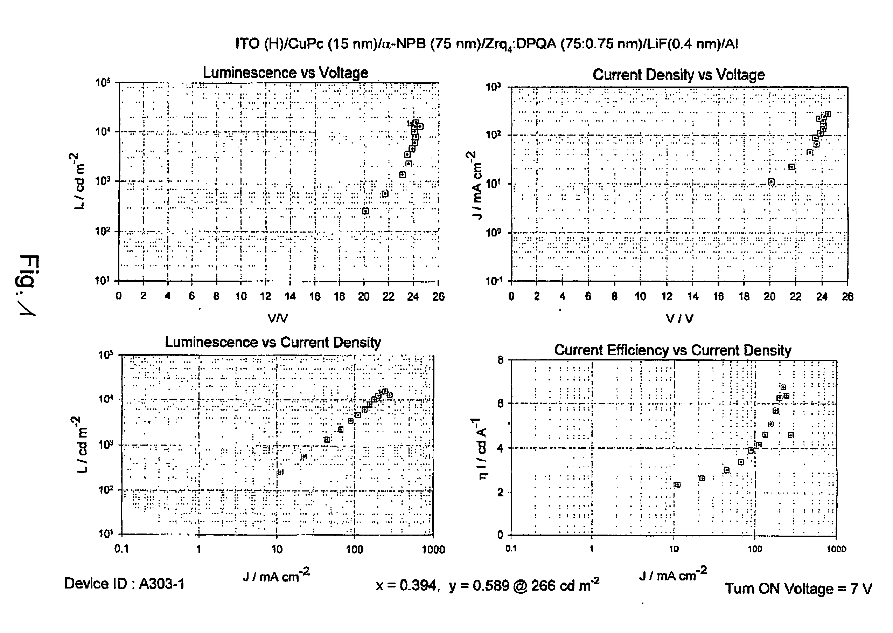

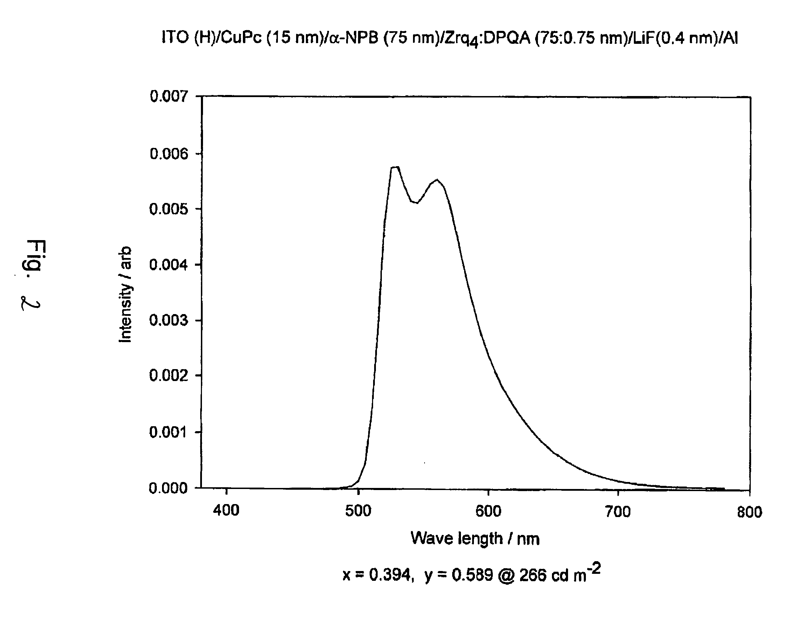

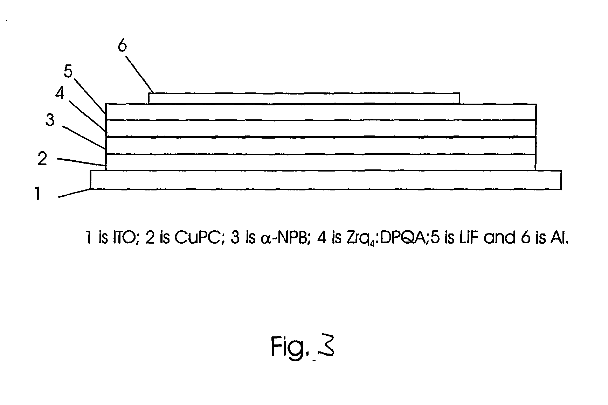

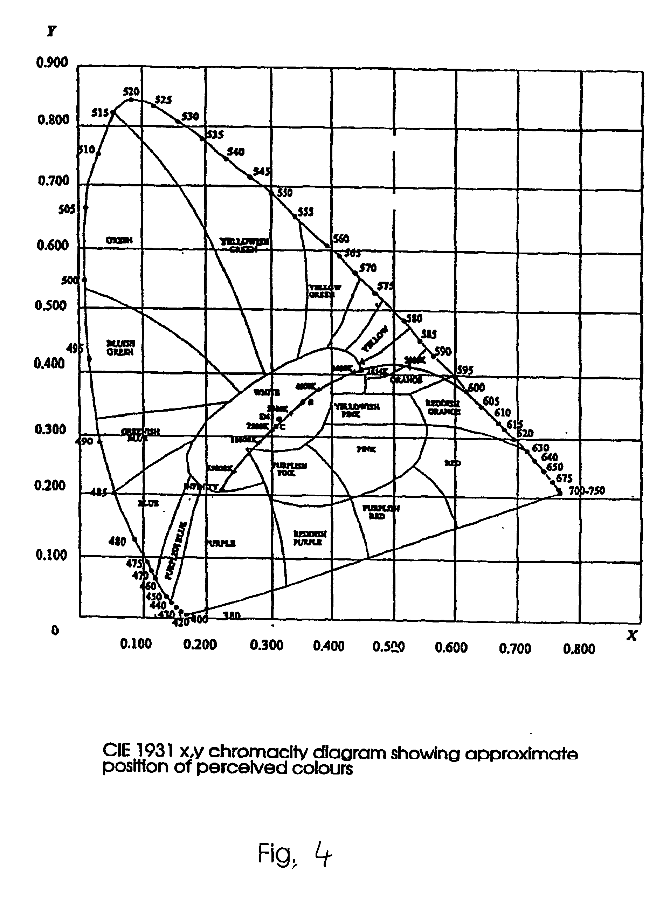

An electric current was applied across the device and the performance shown in fig. 1; the electroluminescence spectrum is shown in fig. 2. The device had the structure of fig. 3 and the colours are as in the CIE colour chart of fig. 4.

### Example 2

A device was fabricated according to the method of Example 1 with the structure
ITO /CuPc (25nm) / α-NPB (75 nm)/Zrq₄:Nilered (75:0.38nm) /LiF (0.4 nm)/Al,
where nilered is

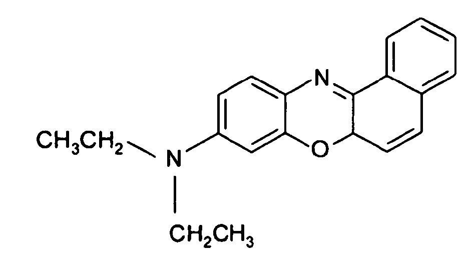

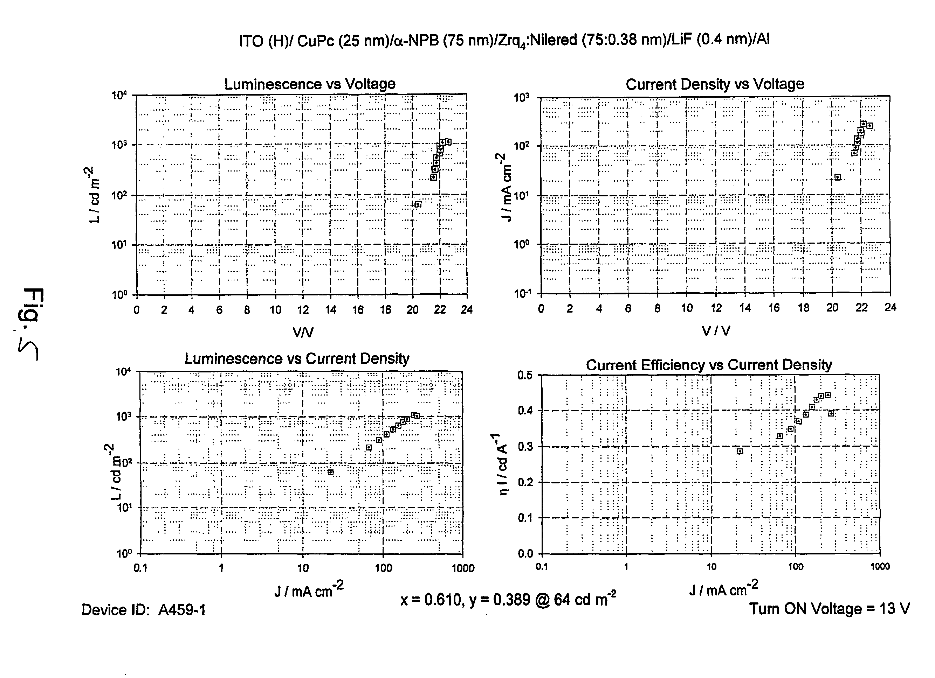

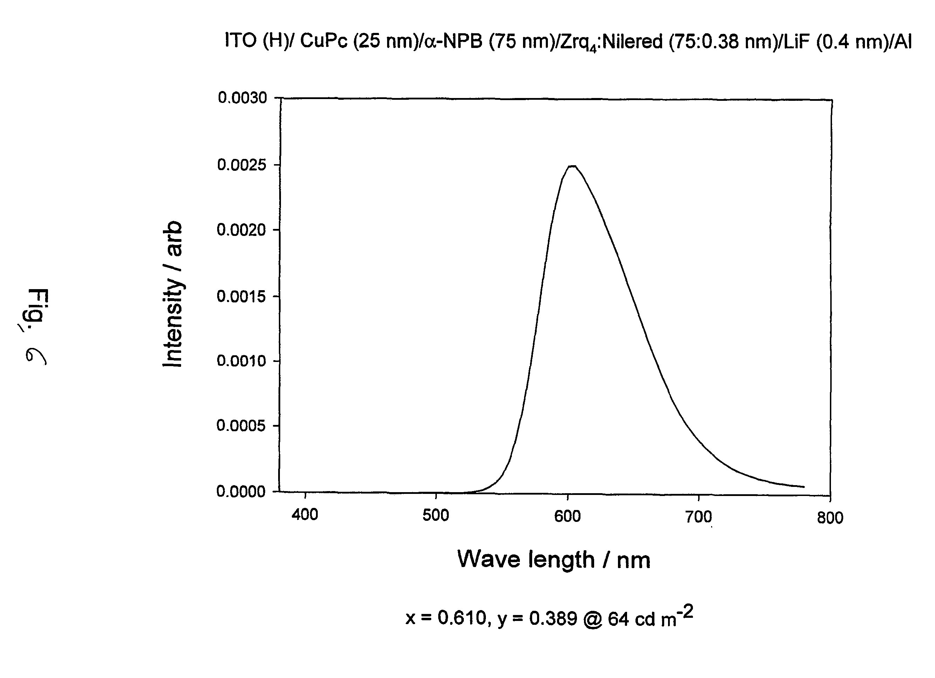

An electric current was applied across the device and the performance shown in fig. 5; the electroluminescence spectrum is shown in fig. 6.

### Example 3

A device was fabricated according to the method of Example 1 with the structure
ITO(100Ω/sqr.m)/CuPc(25nm)/α-NPB(75nm)/Zrq₄:DPQA(60:0.4nm)/Zrq₄(10nm)/LiF (0.4 nm)/Al.

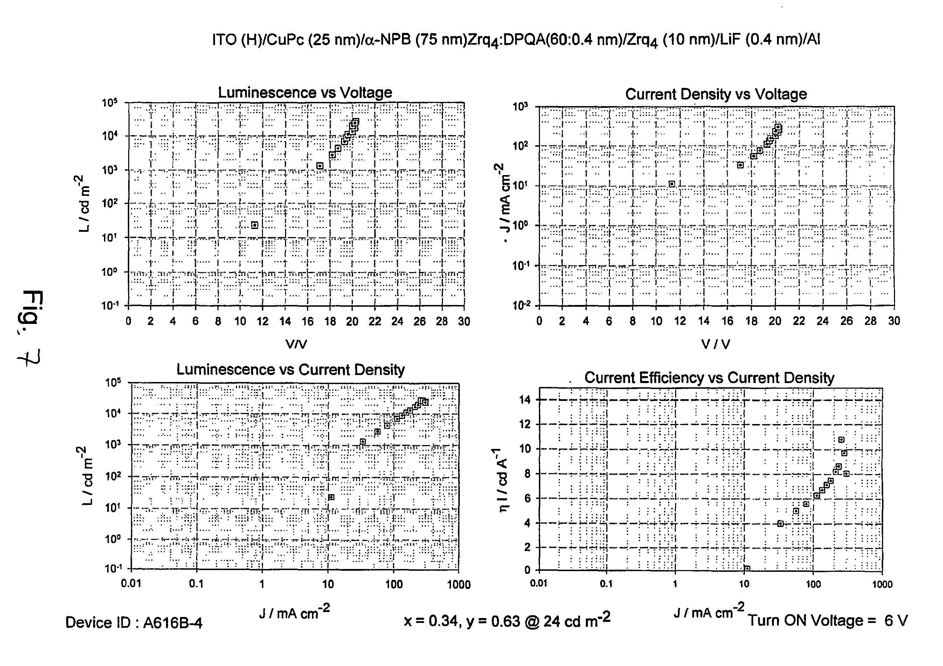

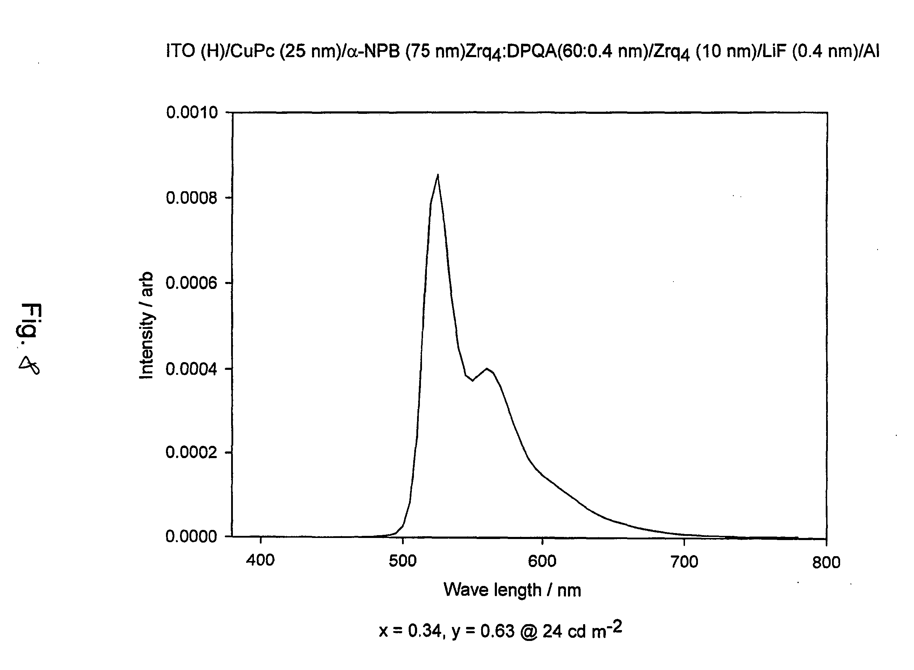

An electric current was applied across the device and the performance shown in fig. 7; the electroluminescence spectrum is shown in fig. 8.

### Example 4

A device was fabricated according to the method of Example 1 with the structure
ITO(100Ω/sqr.m ) /CuPc:TPTP (15:15nm) /α-NPB (75 nm)/Zrq₄:DPQA (60:0.5nm) /LiF (0.2 nm)/Al.

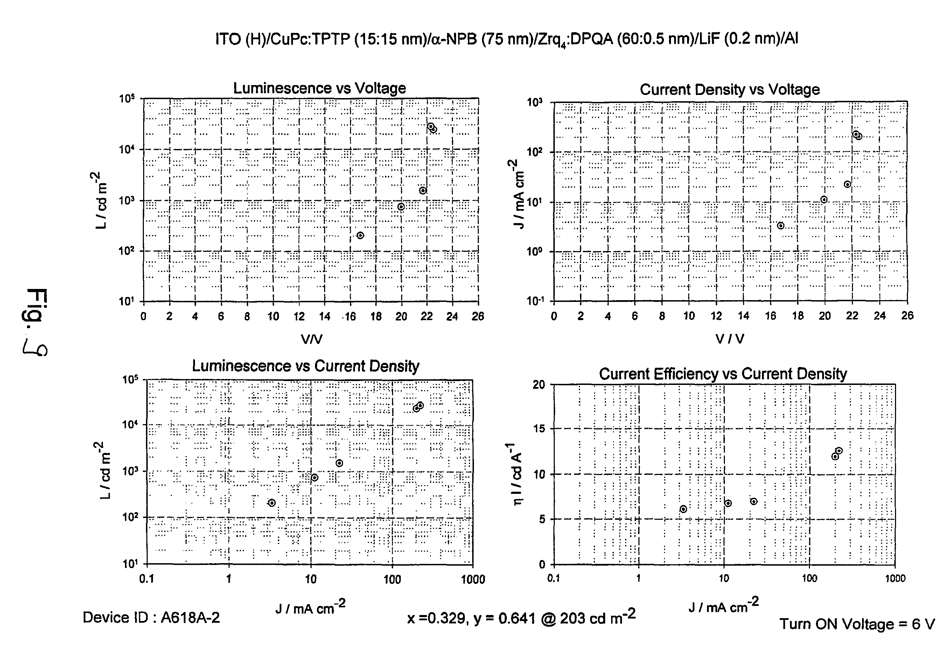

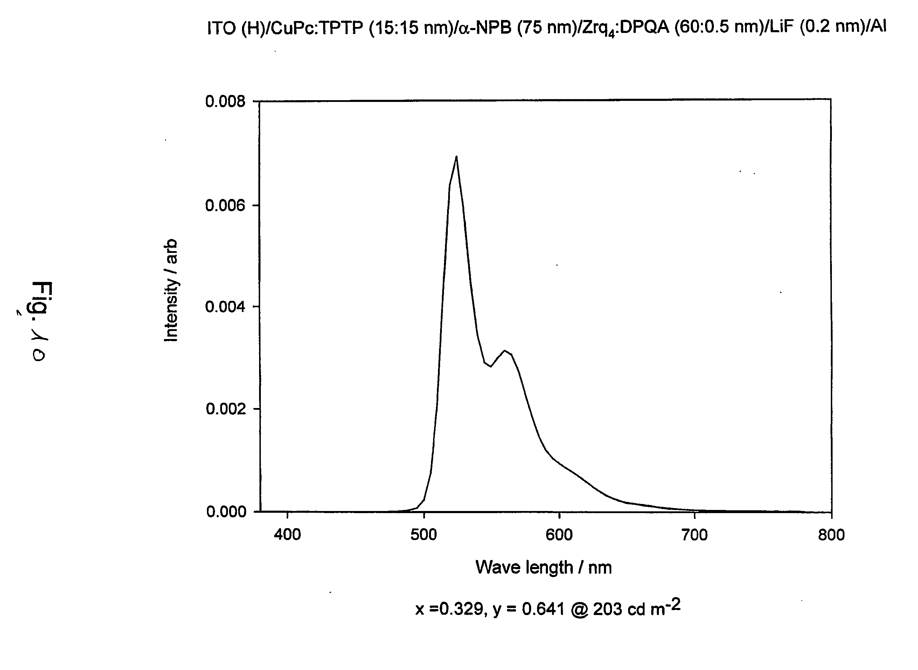

An electric current was applied across the device and the performance shown in fig. 9; the electroluminescence spectrum is shown in fig. 10.

### Example 5

A device was fabricated according to the method of Example 1 with the structure
ITO(100Ω/sqr.m ) /CuPc (25nm) / α-NPB (75 nm)/Zrq₄:DPQA (60:0.4nm) / Zrq₄/LiF (0.4 nm)/Al.

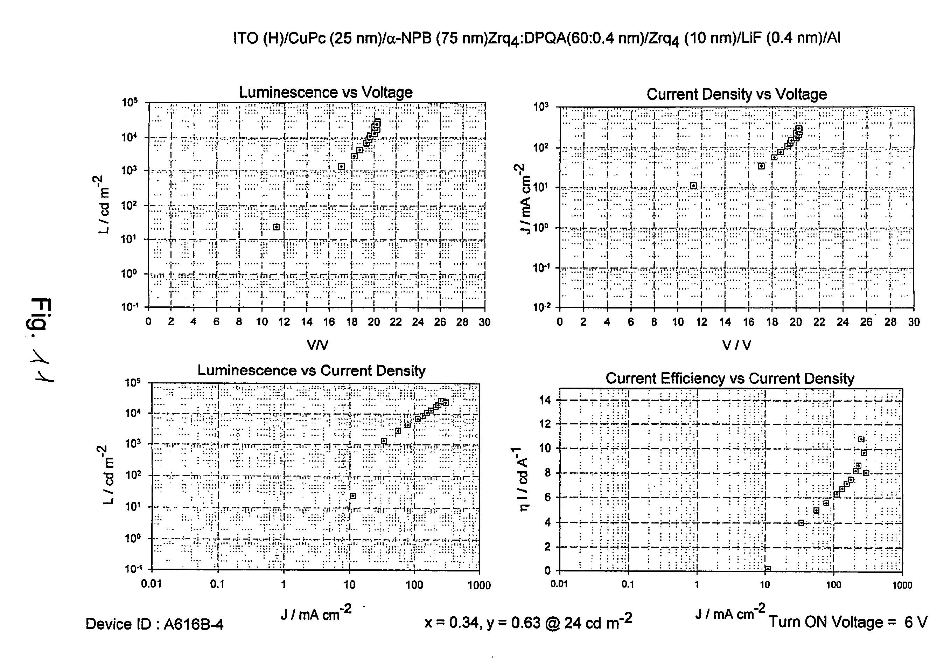

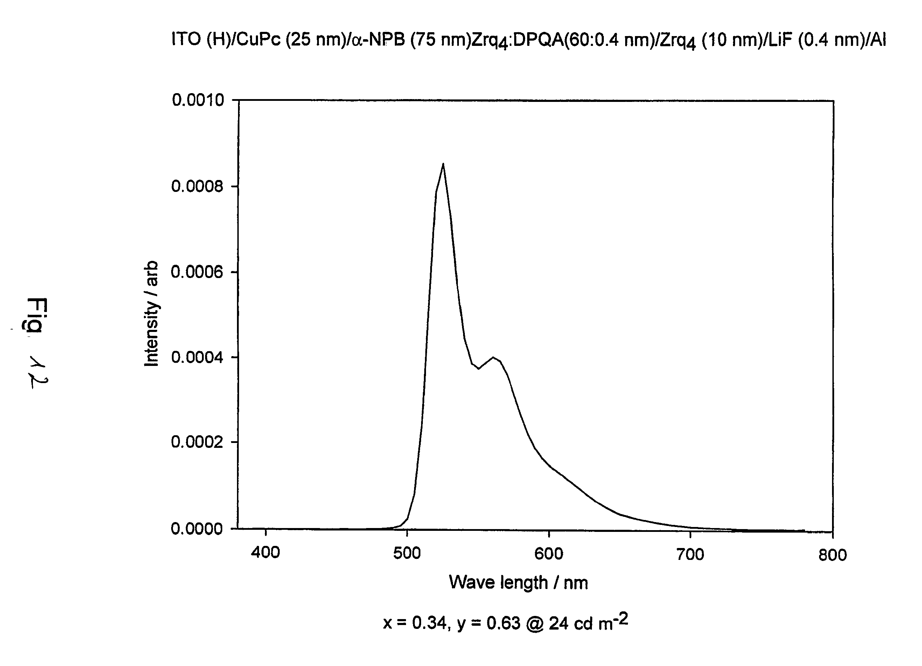

An electric current was applied across the device and the performance shown in fig. 11; the electroluminescence spectrum is shown in fig. 12.

### Example 6

A device was fabricated according to the method of Example 1 with the structure
ITO(100Ω/sqr.m)/CuPc(25nm)/α-NPB 60nm)/Zrq₄:DCJT(35:0.5nm)/ Zrq₄(35nm/LiF (0.5 nm)/Al.
where DCJT is 4-(Dicyanomethylene)-2-methyl-6-(julolidin-4-yl-vinyl)-4H-pyran.

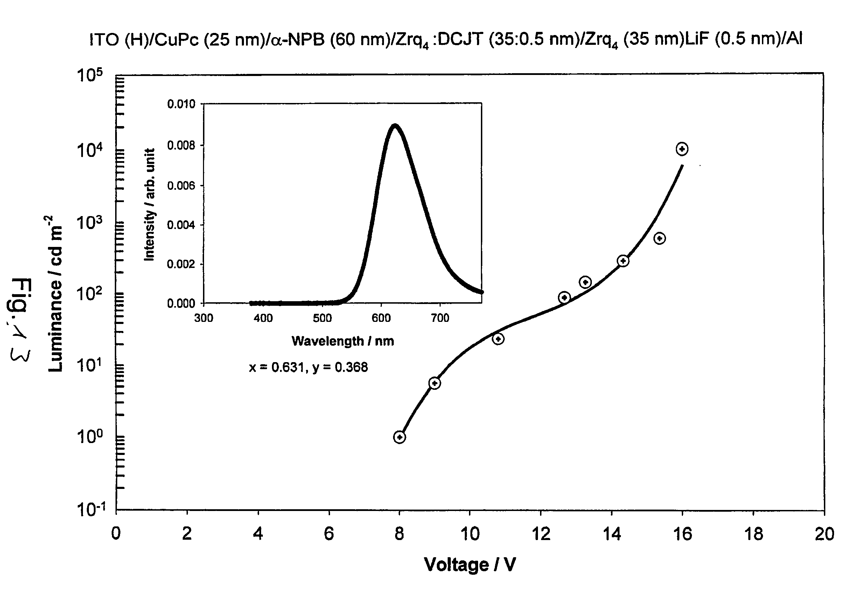

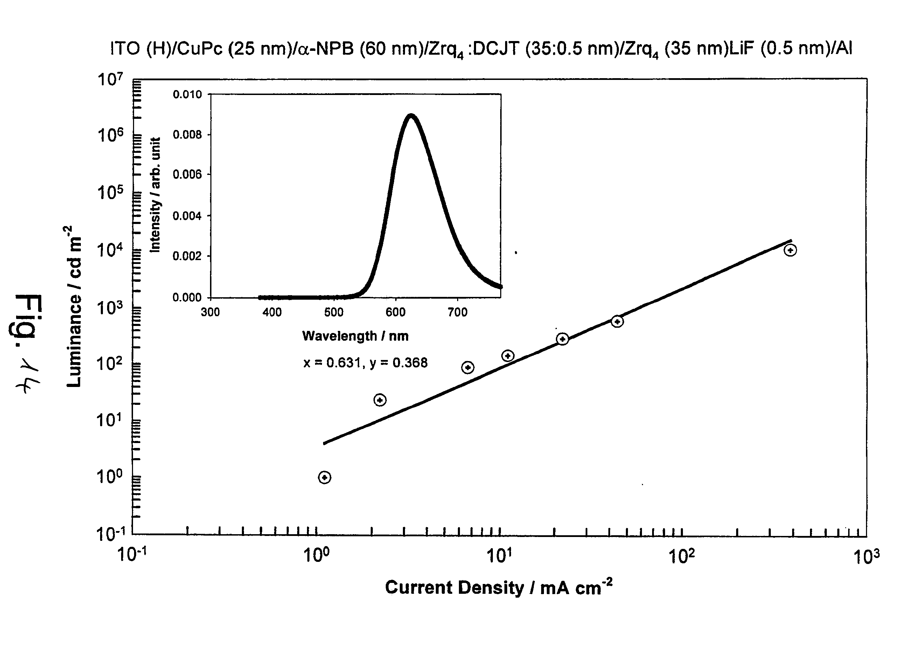

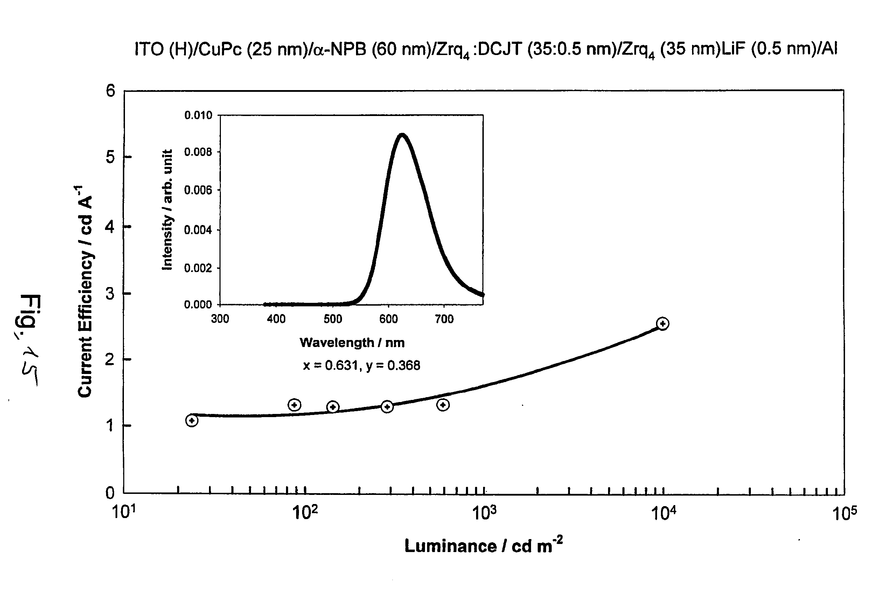

An electric current was applied across the device and the performance shown in figs. 13 to 15.

### Example 7

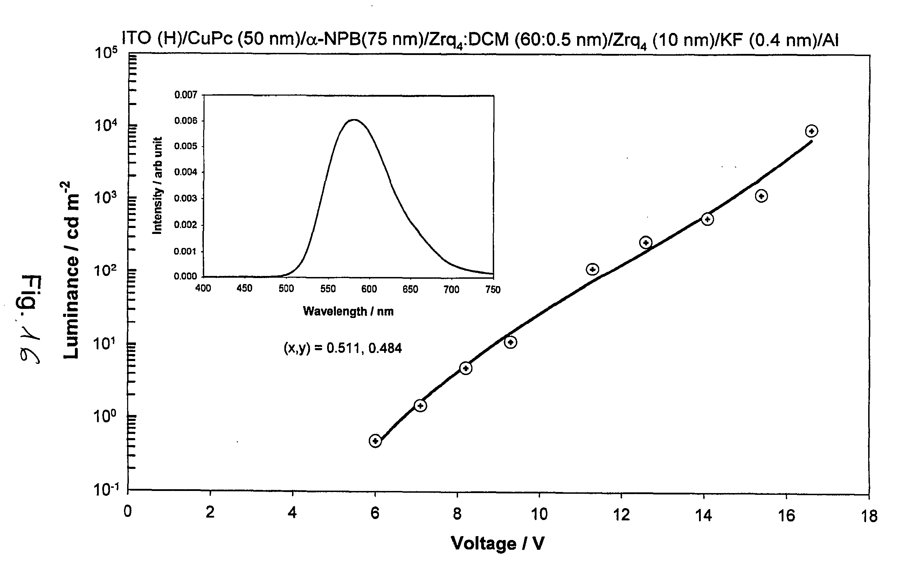

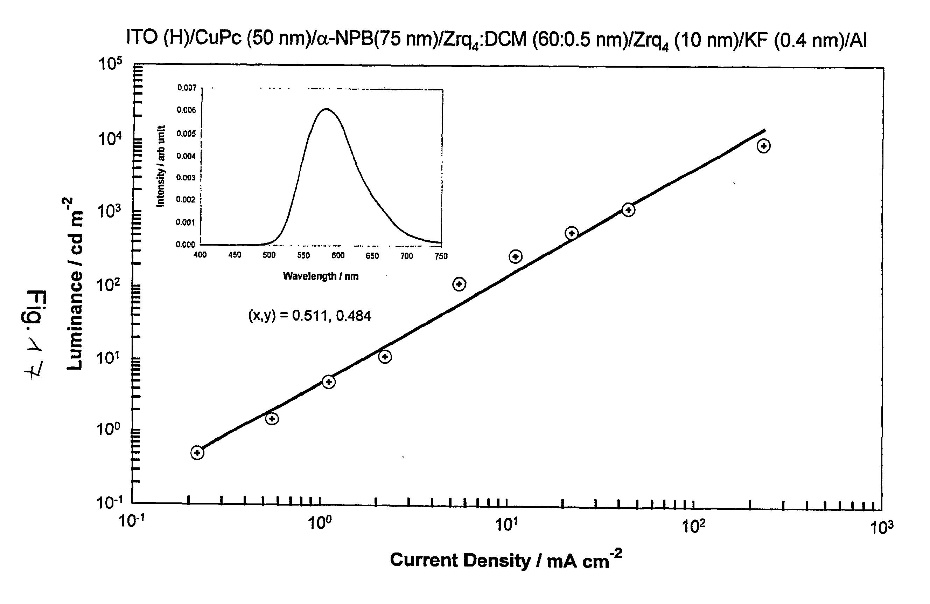

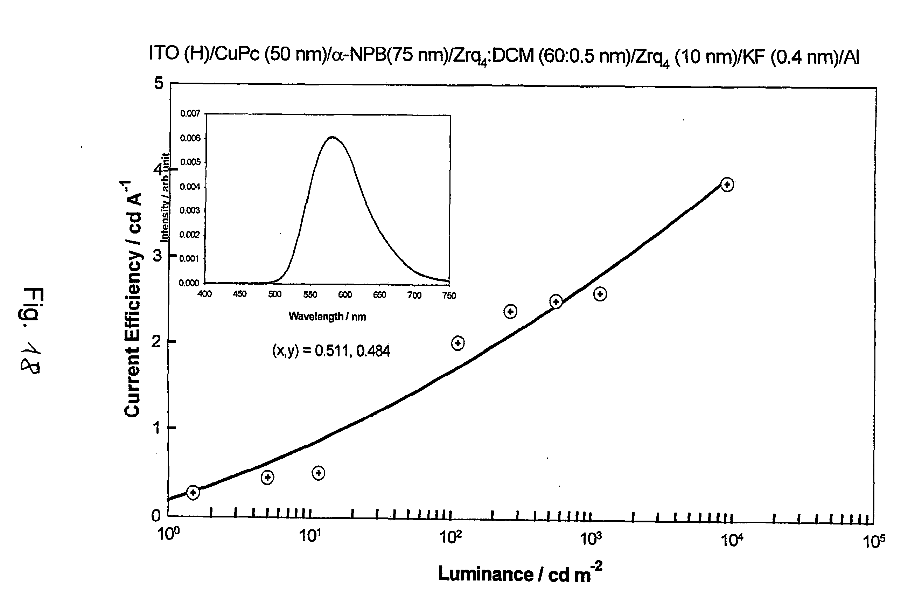

A device was fabricated according to the method of Example I with the structure
ITO(100Ω/ sqr. m) /CuPc (50nm) / α-NPB (75 nm)/Zrq₄:DCM (60:0.5nm) /Zrq₄(10nm/KF (0.4 nm)/Al.
where KF is potassium fluoride and where DCM is 4-(Dicyanomethylene)-2-methyl-6-(p-dimethylaminostyryl)-4H-pyran.
An electric current was applied across the device and the performance shown in figs. 16 to 18.

### Example 8

A device was fabricated according to the method of Example 1 with the structure
ITO(100Ω/sqr.m)/CuPc(50nm)/α-NPB(75nm)/Zrq₄:DPQA(60:0.5nm)/Zrq₄(35nm)/LiF (0.5 nm)/Al.

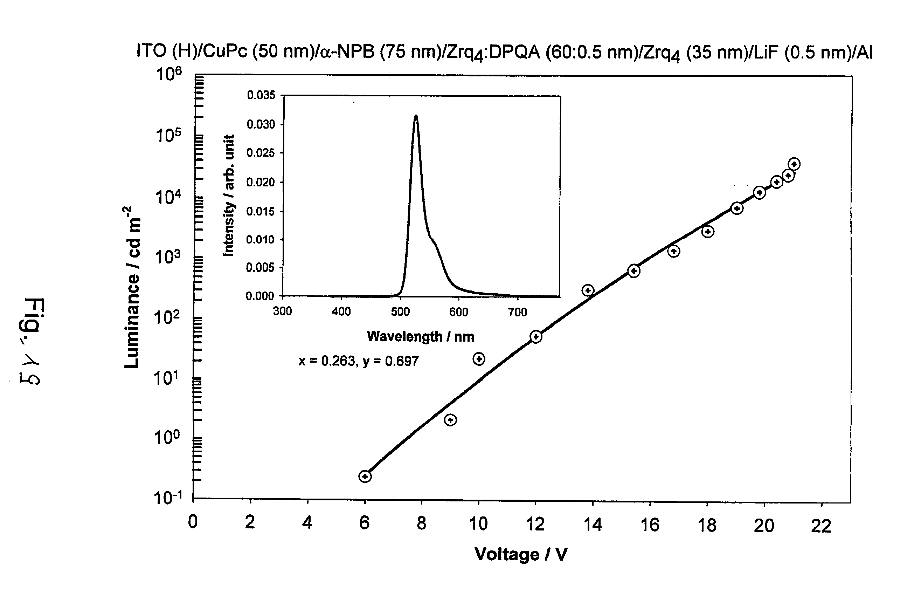

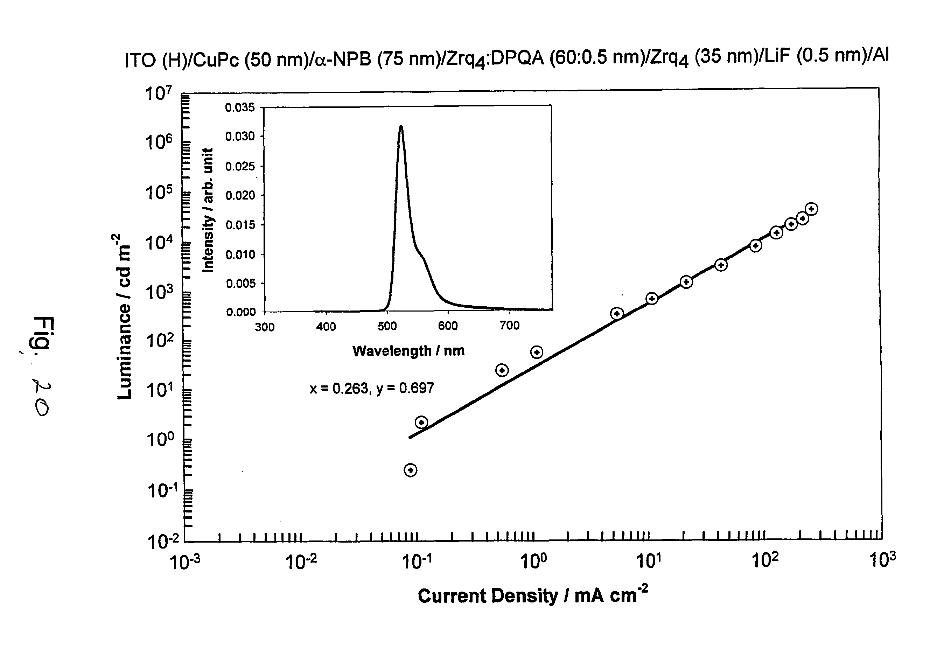

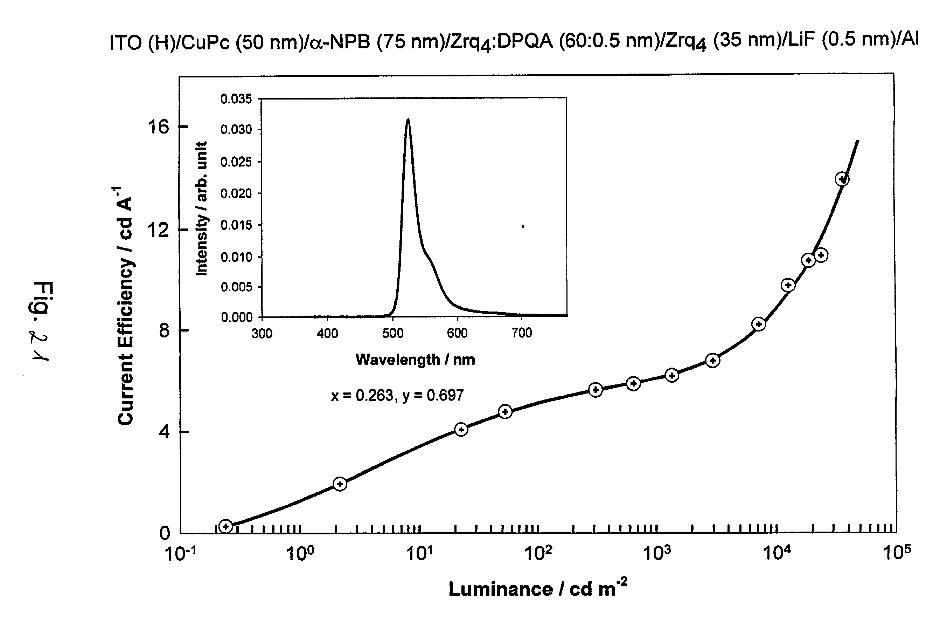

An electric current was applied across the device and the performance shown in figs. 19-21.

### Example 9

A device was fabricated according to the method of Example I with the structure
ITO(100Ω/sqr.m)/CuPc(25nm)/α-NPB(40nm)/Zrq₄:DPQA(30:0.2nm)/Zrq₄(10nm)/LiF (0.5 nm)/Al.

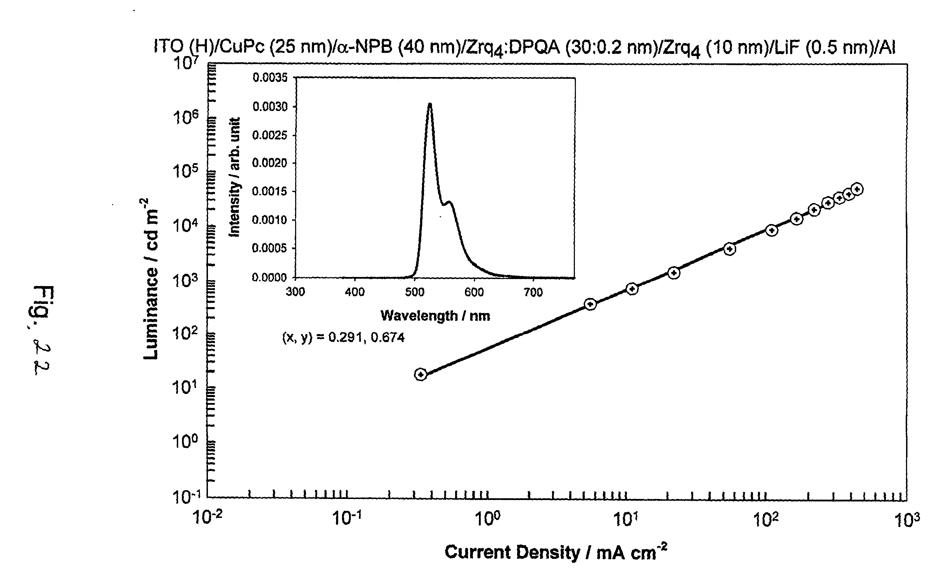

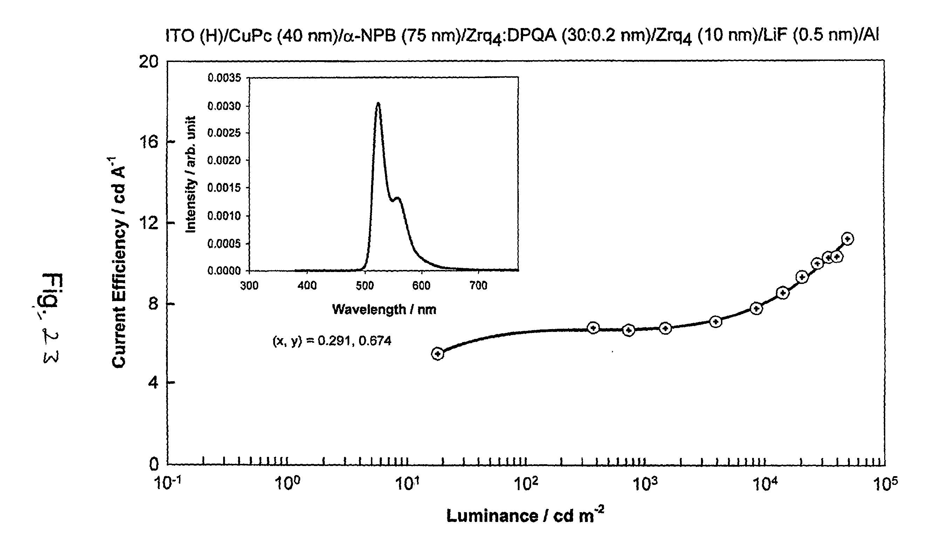

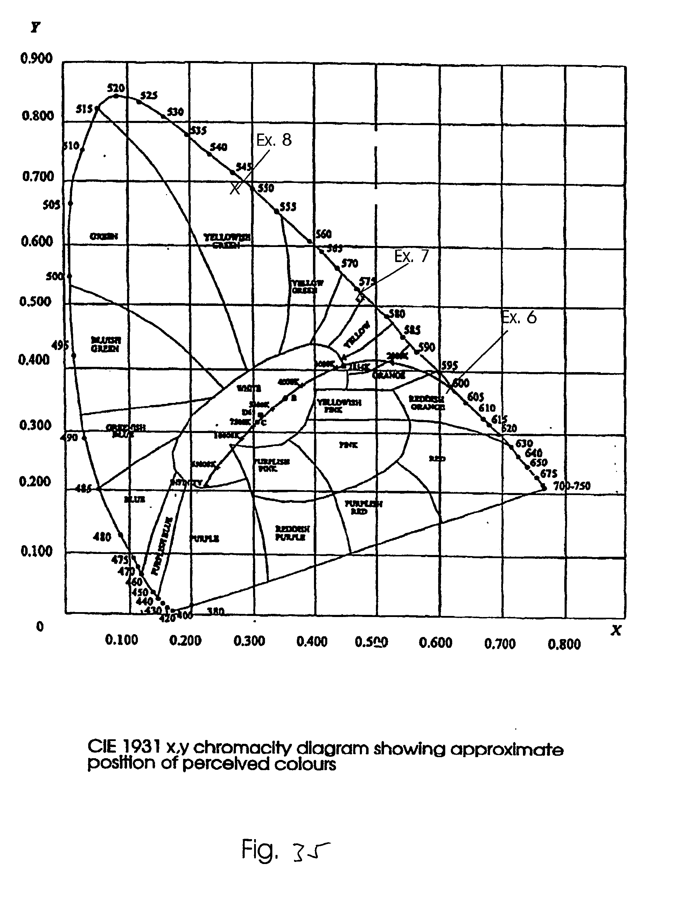

An electric current was applied across the device and the performance shown in figs. 22-23. In fig. 35 are shown the colours of some of the examples on the CIE chart.

### Example 10

### Comparison of Zirconium and aluminium quinolate (Zrq₄ with Alq₃).

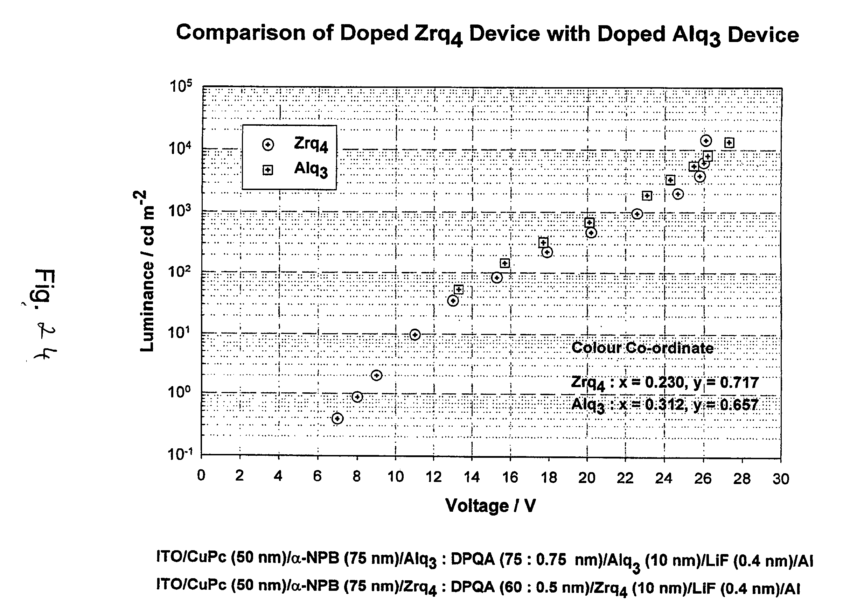

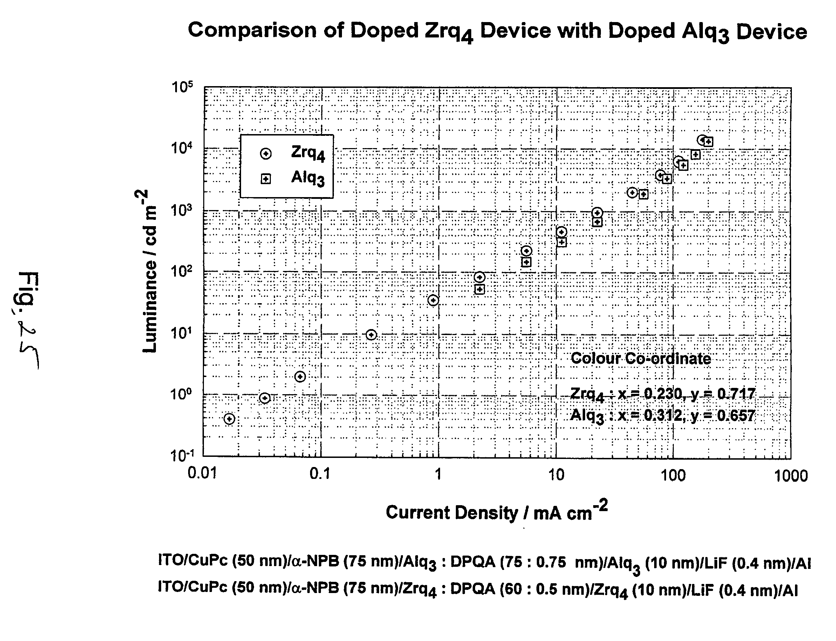

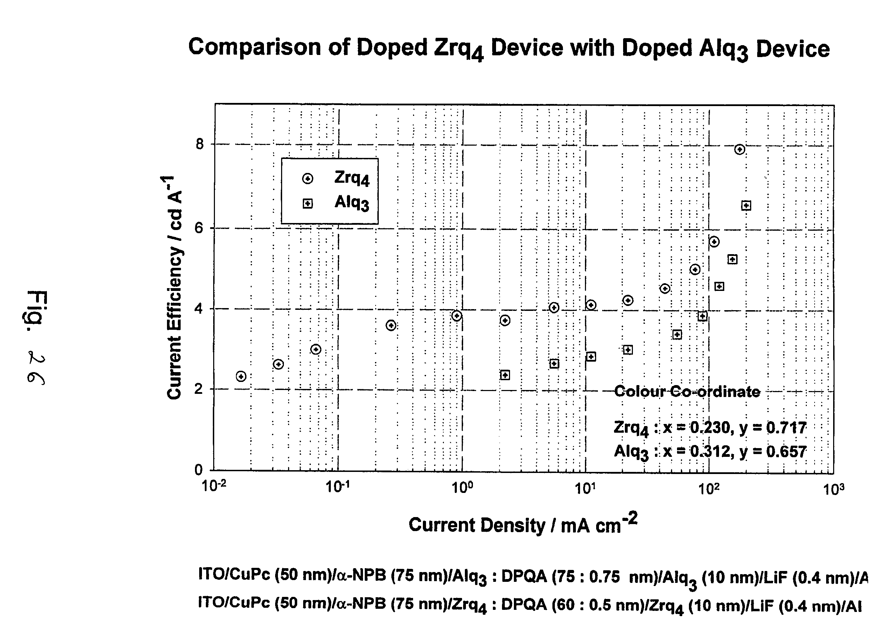

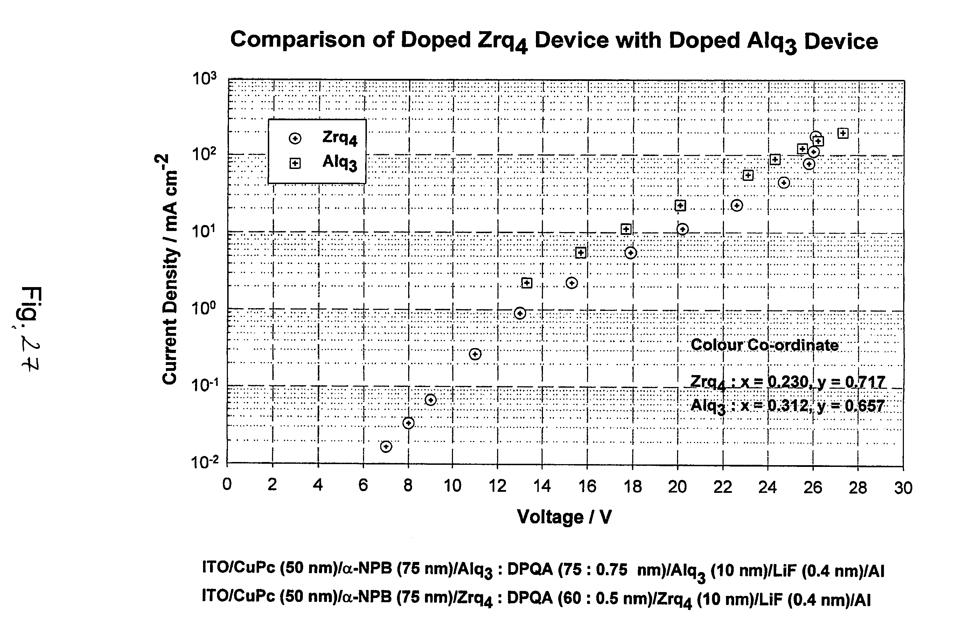

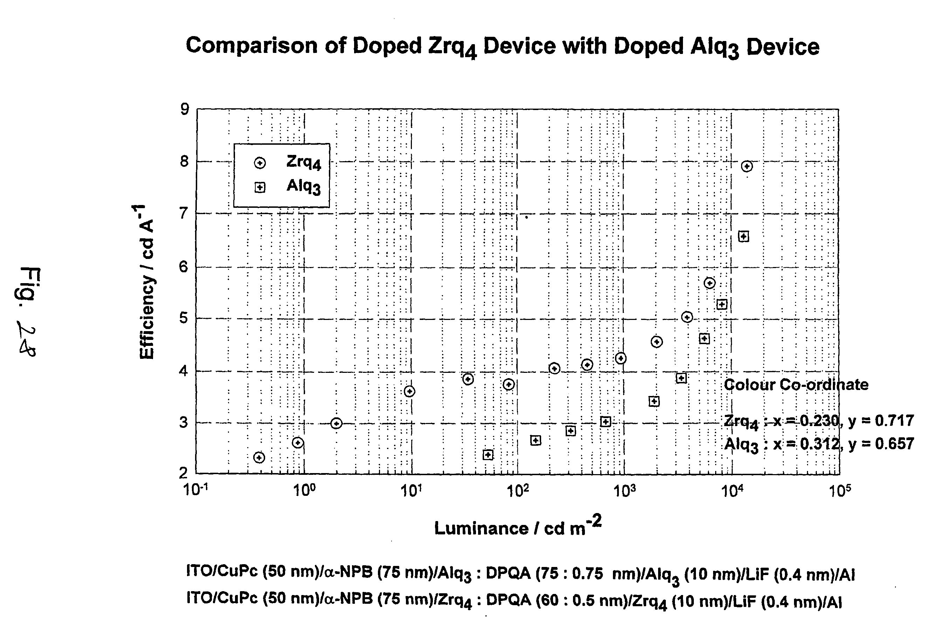

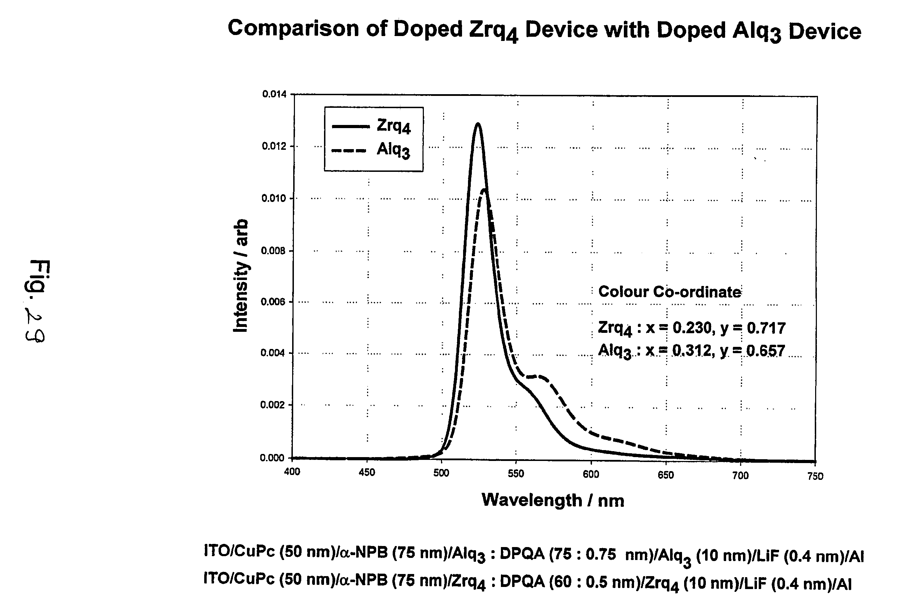

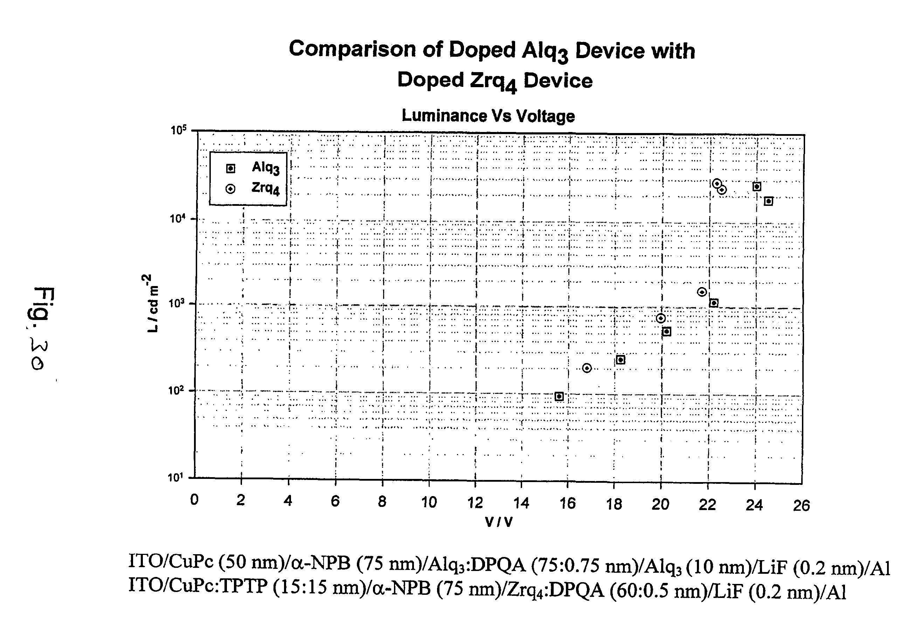

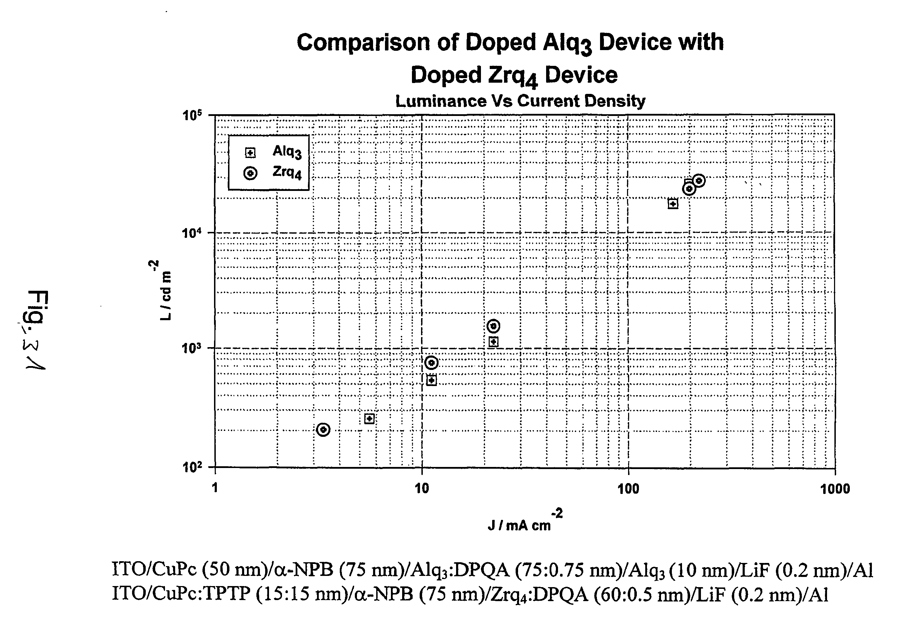

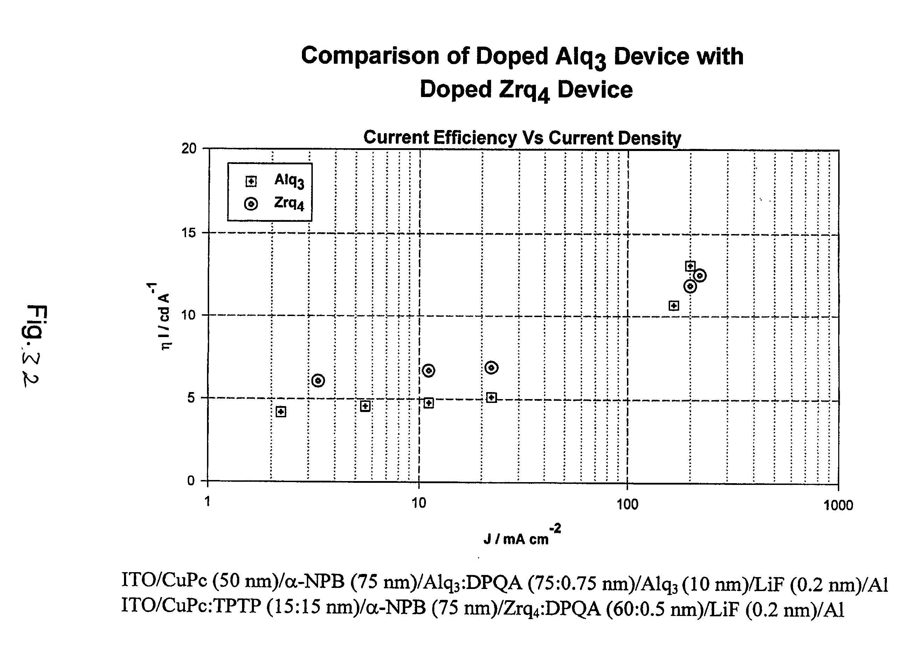

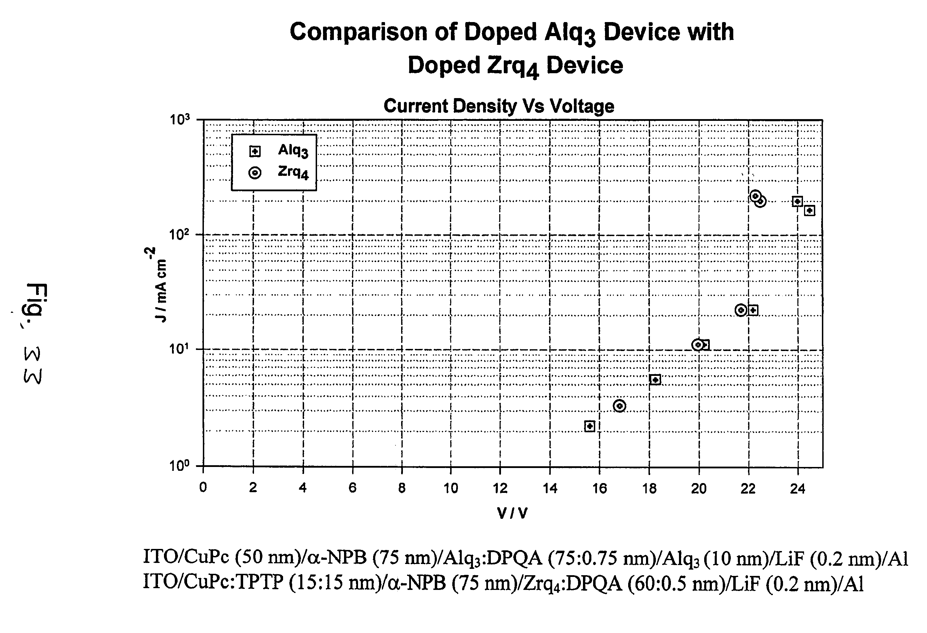

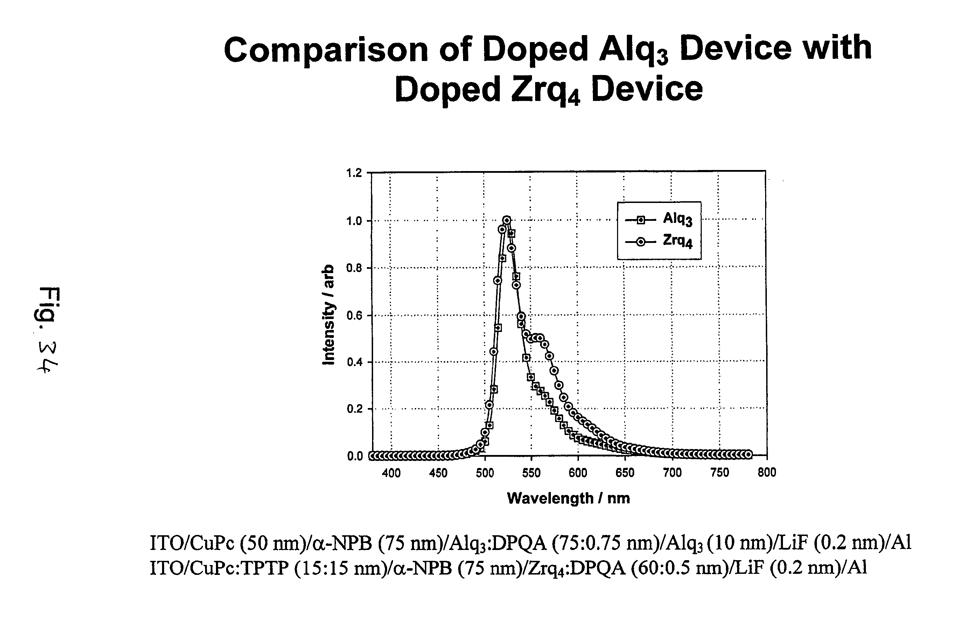

A comparison of zirconium and aluminium quinolates as electroluminescent materials was made under identical conditions. The devices were fabricated by the same method according to Example 1. The results are shown graphically in figs 24 to 34 with the electroluminescent devices as in the figures. The comparison is shown in Table 1.

**Table 1**

| Performance | Alq₃ | Zrq₄ |
|---|---|---|
| Efficiency / cd A⁻¹ @ 300 cd m⁻² | 5 | 7 |
| Luminance / cd m⁻² @ 20 mA cm⁻² | 1100 | 1500 |
| Peak Luminance / cd m⁻² | 2.5 x 10⁴ | 2.8 x 10⁴ |
| Turn on Voltage / V | 7 | 6 |

As can be seen the Zrq₄ had an increase in efficiency of 40% compared with Alq₃ at 300 cd m⁻² and a luminance 36% greater at 20 mA cm⁻² .

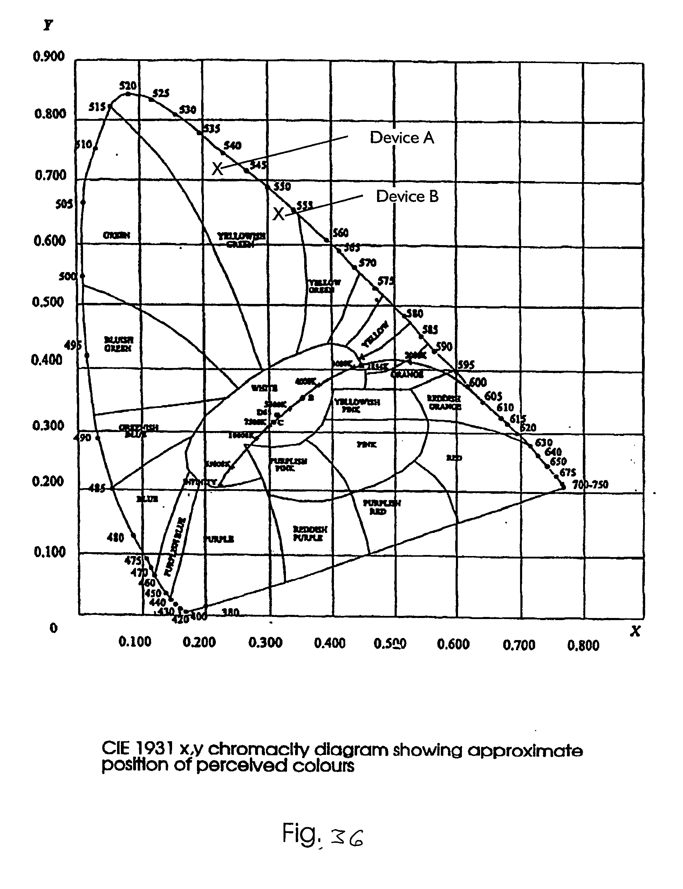

Referring to figs. 24 to 34, there is a marked increase in efficiency and improved luminance and lower current density with no reduction or with an improvement in other properties. The colour emitted is improved compared with aluminium quinolate as is shown by the colour coordinates and illustrated in fig. 36 which shows a CIE colour chart with the colour of emissions of devices A and B where devices A and B had the structure of figs. 24-29.

## Claims

1. Use in an electroluminescent device comprising
(i) a first electrode,
(ii) a layer of electroluminescent composition which comprises a metal quinolate doped with 10⁻³-10 mole% of a fluorescent dopant and
(iii) a second electrode
of zirconium or hafnium quinolate as said metal quinolate to give improved luminance efficiency measurable as cd A⁻¹, luminance measurable as cd m⁻² at 20 mA cm⁻² and reduced turn-on voltage compared with aluminium quinolate.

2. The use of claim 1, wherein the dopant is selected from diphenylacridine, coumarins, perylene, quinolates, porphyrins, porphines, pyrazalones and their derivatives.

3. The use of claim 1 or 2, wherein there is a layer of a hole transmitting material between the first electrode and the layer of the electroluminescent composition and there is a layer of an electron transmitting material between the second electrode and the layer of the electroluminescent composition.

4. The use of claim 3, wherein the hole transmitting layer is an aromatic amine

5. The use of claim 4, wherein the aromatic amine is N,N'-diphenyl-N,N'-bis (3-methylphenyl) -1,1' -biphenyl -4,4'-diamine (TPD) or α-NBP.

6. The use of claim 3, 4 or 5, wherein the electron transmitting layer comprises a metal quinolate.

7. The use of claim 3,4 or 5, wherein the electron transmitting layer comprises lithium quinolate.

8. The use of claim 3, 4 or 5, wherein the electron transmitting layer comprises aluminium quinolate.

9. The use of claim 3, 4 or 5, wherein the electron transmitting layer comprises zirconium quinolate.

10. The use of any preceding claim, wherein the first electrode is the anode and is formed of a transparent electrically conducting glass or plastic electrode.

11. The use of claim 10, wherein the second electrode is the cathode and is selected from aluminium, calcium, lithium, magnesium and alloys thereof and silver/magnesium alloys.

## Patentansprüche

1. Verwendung in einer Elektrolumineszenzvorrichtung, umfassend
(i) eine erste Elektrode,
(ii) eine Schicht einer elektrolumineszierenden Zusammensetzung, die ein Metallchinolat umfaßt, das mit 10⁻³ bis 10 Mol-% eines fluoreszierenden Dotierungsmittels dotiert ist, und
(iii) eine zweite Elektrode,
von Zirconium- oder Hafniumchinolat als das Metallchinolat, so daß im Vergleich mit Aluminiumchinolat ein besserer Wirkungsgrad der Lumineszenz, der als cd A⁻¹ gemessen werden kann, eine bessere Lumineszenz, die als cd m⁻² bei 20 mA cm⁻² gemessen werden kann, und eine geringere Windungsspannung erreicht wird.

2. Verwendung nach Anspruch 1, wobei das Dotierungsmittel aus Diphenylacridin, Cumarinen, Perylen, Chinolaten, Porphyrinen, Porphinen, Pyrazolonen und deren Derivaten ausgewählt ist.

3. Verwendung nach Anspruch 1 oder 2, wobei zwischen der ersten Elektrode und der Schicht der elektrolumineszierenden Zusammensetzung eine Schicht eines Löcher hindurchlassenden Materials vorliegt und zwischen der zweiten Elektrode und der Schicht der elektrolumineszierenden Zusammensetzung eine Schicht eines Elektronen hindurchlassenden Materials vorliegt.

4. Verwendung nach Anspruch 3, wobei die Löcher hindurchlassende Schicht ein aromatisches Amin ist.

5. Verwendung nach Anspruch 4, wobei das aromatische Amin N,N'-Diphenyl-N,N'-bis(3-methylphenyl)-1,1'-biphenyl-4,4'-diamin (TPD) oder α-NBP ist.

6. Verwendung nach Anspruch 3, 4 oder 5, wobei die Elektronen hindurchlassende Schicht ein Metallchinolat umfaßt.

7. Verwendung nach Anspruch 3, 4 oder 5, wobei die Elektronen hindurchlassende Schicht Lithiumchinolat umfaßt

8. Verwendung nach Anspruch 3, 4 oder 5, wobei die Elektronen hindurchlassende Schicht Aluminiumchinolat umfaßt.

9. Verwendung nach Anspruch 3, 4 oder 5, wobei die Elektronen hindurchlassende Schicht Zirconiumchinolat umfaßt

10. Verwendung nach einem der vorstehenden Ansprüche, wobei die erste Elektrode die Anode ist und aus einer transparenten, elektrisch leitenden Glas- oder Kunststoffelektrode gebildet ist.

11. Verwendung nach Anspruch 10, wobei die zweite Elektrode die Kathode ist und aus Aluminium, Calcium, Lithium Magnesium und Legierungen davon und Silber/Magnesium-Legierungen ausgewählt ist.

## Revendications

1. Utilisation dans un dispositif électroluminescent comprenant :
(i) une première électrode,
(ii) une couche d'une composition électroluminescente qui comporte un quinoléate de métal dopé avec 10⁻³-10 mole % d'un dopant fluorescent et
(iii) une seconde électrode
de quinoléate de zirconium ou d'hafnium en tant que dit quinoléate de métal pour donner une efficacité de luminance améliorée mesurable en cd A⁻¹, une luminance mesurable en cd m⁻² à 20 mA cm⁻² et une tension d'enclenchement réduite comparée au quinoléate d'aluminium.

2. Utilisation selon la revendication 1, dans laquelle le dopant est choisi parmi la diphénylacridine, les coumarines, le pérylène, les quinoléates, les porphyrines, les porphines, les pyrazolones et leurs dérivés.

3. Utilisation selon la revendication 1 ou 2, dans laquelle il existe une couche d'un matériau émetteur de trous entre la première électrode et la couche de la composition électroluminescente et il existe une couche d'un matériau émetteur d'électrons entre la seconde électrode et la couche de la composition électroluminescente.

4. Utilisation selon la revendication 3, dans laquelle la couche d'émission de trous est une amine aromatique.

5. Utilisation selon la revendication 4, dans laquelle l'amine aromatique est la N,N'-diphényl-N,N'-bis(3-méthylphényl)-1,1'-biphényl -4, 4' -diamine (TPD) ou du α-NBP.

6. Utilisation selon la revendication 3, 4 ou 5, dans laquelle la couche d'émission d'électrons comporte un quinoléate de métal.

7. Utilisation selon la revendication 3, 4 ou 5, dans laquelle la couche d'émission d'électrons comporte du quinoléate de lithium.

8. Utilisation selon la revendication 3, 4 ou 5, dans laquelle la couche d'émission d'électrons comporte du quinoléate d'aluminium.

9. Utilisation selon la revendication 3, 4 ou 5, dans laquelle la couche d'émission d'électrons comporte du quinoléate de zirconium.

10. Utilisation selon l'une quelconque des revendications précédentes, dans laquelle la première électrode est l'anode et est formée d'une électrode de plastique ou de verre transparent, électriquement conducteur.

11. Utilisation selon la revendication 10, dans laquelle la seconde électrode est la cathode et est choisie parmi l'aluminium, le calcium, le lithium, le magnésium et leurs alliages et alliages d'argent et de magnésium.
